# EUROPEAN PATENT APPLICATION

(11) **EP 2 858 250 A1**
(43) Date of publication of application: **08.04.2015**
(21) Application number: 13797258.4
(22) Date of filing: 22.05.2013
(51) Int. Cl.: H03M 13/41, H03M 13/27, H03M 13/29

(54) **RECEPTION DEVICE AND RECEPTION METHOD**

(30) Priority: 31.05.2012 JP 2012124391
(71) Applicant: Sony Corporation, Tokyo 108-0075 (JP)
(72) Inventor: YOKOKAWA Takashi, Tokyo 108-0075 (JP); SHINOHARA Yuji, Tokyo 108-0075 (JP); NANIWADA Koji, Tokyo 108-0075 (JP); IKEGAYA Ryoji, Tokyo 108-0075 (JP)
(74) Representative: MFG Patentanwälte Meyer-Wildhagen Meggle-Freund Gerhard PartG mbB
(86) International application number: PCT/JP2013/064224
(87) International publication number: WO 2013/179974

(57) **Abstract**

There is provided a receiving device including a receiving unit configured to receive encoded data encoded by one or more codes, a first decoding unit configured to decode the encoded data received by the receiving unit, a first delay unit configured to delay a part of decoding results obtained by the first decoding unit, and a reliability increasing unit configured to control decoding of the encoded data to increase reliability of the decoding results using a decoding result that is not delayed by the first delay unit among the decoding results after delay by the first delay unit.

## Description

### Technical Field

The present disclosure relates to a receiving device and a receiving method, and particularly, to a receiving device and a receiving method capable of decreasing a memory for an error correction process.

### Background Art

First generation terrestrial digital broadcasting standards include Integrated Services Digital Broadcasting-Terrestrial (ISDB-T), Digital Video Broadcasting-Terrestrial (DVB-T), Advanced Television Systems Committee (ATSC), Integrated Services Digital Broadcasting-Satellite (ISDB-S), Digital Video Broadcasting-Satellite (DVB-S), and the like which use a Reed Solomon (RS) code as an external code and a convolutional code as an internal code of an error correcting code.

In addition, practical use of second generation terrestrial digital broadcasting standards including Digital Video Broadcasting-Terrestrial 2 (DVB-T2), Digital Video Broadcasting-Cable 2 (DVB-C2), and Digital Video Broadcasting-Satellite 2 (DVB-S2) which use Bose Chaudhuri Hocquenghem (BCH) as an external code and low density parity check (LDPC) as an internal code of an error correcting code has begun.

In the related art, an error correcting unit of a receiving device compliant with a first generation terrestrial digital broadcasting standard is implemented by a pipeline connection of a Viterbi decoding unit, a convolutional de-interleaver, and an RS decoding unit.

However, recently, stable reception of terrestrial digital broadcasting has been required even for moving objects. Therefore, a diversity receiving technique, an error correction technique, and the like have been studied to increase reception performance.

For example, in the ISDB-T standard, in order to increase reception performance, introducing a space diversity technique using a plurality of receiving antennas and a concept of iterative decoding to the error correcting unit has been devised (for example, refer to Non-Patent Literature 1).

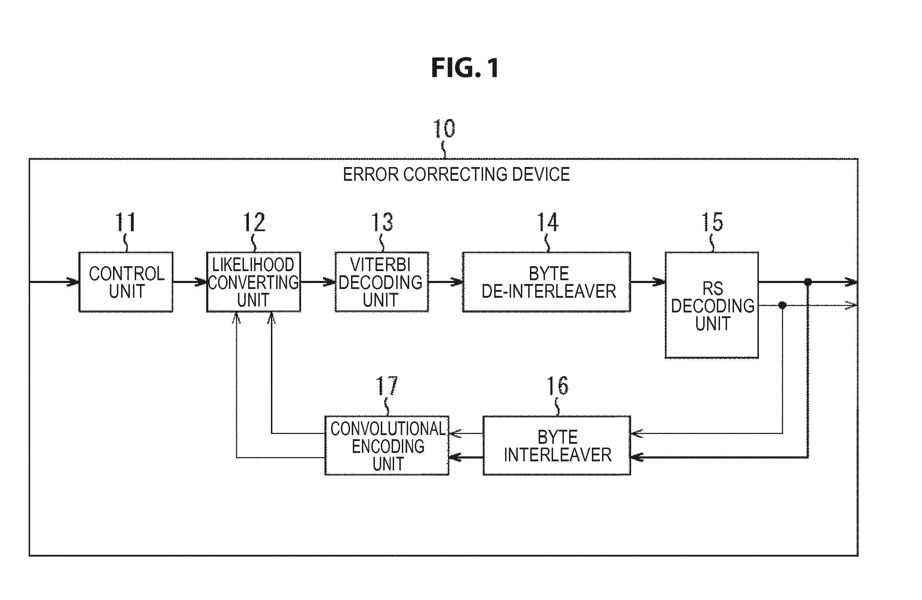

FIG. 1 is a block diagram illustrating a configuration example of an error correcting device of the invention described in Non-Patent Literature 1.

An error correcting device 10 of FIG. 1 includes a control unit 11, a likelihood converting unit 12, a Viterbi decoding unit 13, a byte de-interleaver 14, an RS decoding unit 15, a byte interleaver 16, and a convolutional encoding unit 17. The error correcting device 10 implements iterative decoding in which the Viterbi decoding unit 13 and the RS decoding unit 15 exchange information.

Specifically, a demapped likelihood that is multi-value demodulated by a demodulating device (not illustrated) is input to the control unit 11 of the error correcting device 10 bit by bit. The control unit 11 includes a built-in memory and temporarily stores the input likelihood in order to read the same likelihood a plurality of times. Then, the control unit 11 reads the likelihood from the built-in memory at a necessary timing and provides the likelihood to the likelihood converting unit 12.

Here, the convolutional code of the ISDB-T standard has a code rate of 1/2, and a code bit of two bits corresponds to an information bit of one bit. Therefore, the control unit 11 provides a likelihood of two bits corresponding to the 1-bit information bit to the likelihood converting unit 12. Further, hereinbelow, when it is necessary to particularly distinguish the likelihoods of two bits, a likelihood #1 and a likelihood #2 are used.

The likelihood converting unit 12 converts the likelihood #1 provided from the control unit 11 based on encoding bit #1 provided from the convolutional encoding unit 17 and reliability information of the encoding bit #1. Similarly, the likelihood converting unit 12 converts the likelihood #2 provided from the control unit 11 based on encoding bit #2 provided from the convolutional encoding unit 17 and reliability information of the encoding bit #2.

Also, hereinbelow, when it is unnecessary to particularly distinguish between the encoding bit #1 corresponding to the likelihood #1 and the encoding bit #2 corresponding to the likelihood #2, these are collectively called an encoding bit. Similarly, reliability information #1 and reliability information #2 are collectively called reliability information.

More specifically, when a level of the reliability information is an H level indicating that the information is reliable, the likelihood converting unit 12 sets a likelihood that is closest to a value of the encoding bit set in advance as a converted likelihood. On the other hand, when a level of the reliability information is an L level indicating that the information is unreliable, the likelihood provided from the control unit 11 is set as a converted likelihood. The likelihood converting unit 12 provides the converted likelihood to the Viterbi decoding unit 13.

The Viterbi decoding unit 13 performs Viterbi decoding on the likelihood provided from the likelihood converting unit 12 and provides a bitwise decoding result to the byte de-interleaver 14.

The byte de-interleaver 14 converts the bitwise decoding result provided from the Viterbi decoding unit 13 into a bytewise decoding result. Also, the byte de-interleaver 14 serves as a delay unit and performs de-interleaving by delaying a part of the bytewise decoding result obtained as a conversion result. Here, in the ISDB-T standard, the number of branches of the byte interleaver is 12 and an i-th (i = 1, ..., and 12) branch includes a memory having a depth of (i-1)×17. The byte de-interleaver 14 is configured to correspond to the byte interleaver.

The RS decoding unit 15 performs RS decoding on the bytewise decoding result de-interleaved by the byte de-interleaver 14. The RS decoding unit 15 outputs decoded data obtained as a result and a decoding success flag indicating whether decoding is successful to the outside, and provides the result to the byte interleaver 16.

The byte interleaver 16 is a byte interleaver in the ISDB-T standard, and the number of branches is 12 and an i-th (i = 1, ..., and 12) branch includes a memory having a depth of (i-1)×17 as described above,. The byte interleaver 16 performs bytewise interleaving by associating the decoded data with the decoding success flag provided from the RS decoding unit 15. The byte interleaver 16 provides the interleaved bytewise decoded data and decoding success flag to the convolutional encoding unit 17.

When first reading of the likelihood is performed by the control unit 11, the convolutional encoding unit 17 provides a predetermined value as the encoding bit and reliability information of the L level to the likelihood converting unit 12. On the other hand, when second or subsequent reading of the likelihood is performed by the control unit 11, the convolutional encoding unit 17 performs convolutional coding by generating the encoding bit based on the bytewise decoded data provided from the byte interleaver 16. In addition, the convolutional encoding unit 17 generates reliability information based on the decoding success flag. Then, the convolutional encoding unit 17 provides the encoding bit and the reliability information to the likelihood converting unit 12.

As described above, in the error correcting device 10, out of likelihoods of each bit that is Viterbi-decoded, since a likelihood of a bit in which RS decoding is successful becomes a likelihood that is closest to the encoding bit, a difference of a branch metric of branches in a trellis corresponding to the bit is large. Therefore, it is possible to select a survival path more accurately and increase a positive decoding probability of Viterbi decoding. In addition, since the decoding result of Viterbi decoding in which the positive decoding probability increased is de-interleaved and becomes a part of an RS codeword to be input to the RS decoding unit 15, a positive decoding probability of RS decoding also increases. As a result, reception performance increases.

Also, such an effect further increases when the Viterbi decoding and the RS decoding are repeated.

### Citation List

### Non-Patent Literature

Non-Patent Literature 1: Y.Narikiyo and M.Takada, "Improvement of HDTV Mobile Reception Performance for ISDB-T Using Iterative Decoding 8-branch Space Diversity Technology, " in IEEE International Symposium on Broadband Multimedia Systems and Broadcasting (BMSB 2011), Nurnberg, Germany, June 2011.

### Summary of Invention

### Technical Problem

However, in the error correcting device 10 of FIG. 1, a capacity of the memory in the control unit 11 in order to provide feedback of all of the decoding success flag and the decoded data output from the byte interleaver 16 may not be ignored even when iterative decoding is performed once, in consideration of the number of bits of the likelihood for each code bit (one bit), and the number of packets corresponding to a delay in the byte interleaver 16. In addition, when iterative decoding is performed N times (N is an integer of 2 or more), a capacity N times the capacity when iterative decoding is performed once is necessary. Also, a memory for the byte interleaver 16 should also be provided in the error correcting device 10.

In view of the aforementioned circumstances, the present disclosure may decrease a memory for an error correction process.

### Solution to Problem

A receiving device of a first aspect of the present disclosure includes a receiving unit configured to receive encoded data encoded by one or more codes, a first decoding unit configured to decode the encoded data received by the receiving unit, a first delay unit configured to delay a part of decoding results obtained by the first decoding unit, and a reliability increasing unit configured to control decoding of the encoded data to increase reliability of the decoding results using a decoding result that is not delayed by the first delay unit among the decoding results after delay by the first delay unit.

A receiving method of a first aspect of the present disclosure corresponds to a receiving device of a first aspect of the present disclosure.

In the first aspect of the present disclosure, decoding of encoded data is controlled such that the encoded data encoded by one or more codes is received, the received encoded data is decoded, a part of the decoding result is delayed, and a decoding result that is not delayed among the decoding results after delay is used to increase reliability of the decoding result.

### Advantageous Effects of Invention

According to the present disclosure, it is possible to decrease a memory for an error correction process.

### Brief Description of Drawings

[FIG. 1] FIG. 1 is a block diagram illustrating a configuration example of an error correcting device in the related art.
[FIG. 2] FIG. 2 is a block diagram illustrating a configuration example of an embodiment of a receiving device to which the present disclosure is applied.
[FIG. 3] FIG. 3 is a block diagram illustrating a first configuration example of an error correcting unit of FIG. 2.
[FIG. 4] FIG. 4 is block diagram illustrating a configuration example of a likelihood converting unit of FIG. 3.
[FIG. 5] FIG. 5 is a block diagram illustrating a configuration example of a convolutional encoding unit of FIG. 3.
[FIG. 6] FIG. 6 is a flowchart illustrating an error correction process of the error correcting unit of FIG. 3.
[FIG. 7] FIG. 7 is a flowchart illustrating details of a first error correction process of FIG. 6.
[FIG. 8] FIG. 8 is a flowchart illustrating details of a likelihood converting process of FIG. 7.
[FIG. 9] FIG. 9 is a flowchart illustrating details of a process of accumulating the number of error bits of FIG. 7.
[FIG. 10] FIG. 10 is a flowchart illustrating details of a second error correction process of FIG. 6.
[FIG. 11] FIG. 11 is a block diagram illustrating a second configuration example of the error correcting unit of FIG. 2.
[FIG. 12] FIG. 12 is a block diagram illustrating a configuration example of a state generating unit of FIG. 11.
[FIG. 13] FIG. 13 is a flowchart illustrating details of a first error correction process of the error correcting unit of FIG. 11.
[FIG. 14] FIG. 14 is a flowchart illustrating details of a Viterbi decoding process of FIG. 13.
[FIG. 15] FIG. 15 is a flowchart illustrating details of a second error correction process of the error correcting unit of FIG. 11.
[FIG. 16] FIG. 16 is a block diagram illustrating a third configuration example of the error correcting unit of FIG. 2.
[FIG. 17] FIG. 17 is a flowchart illustrating details of a first error correction process of the error correcting unit of FIG. 16.
[FIG. 18] FIG. 18 is a flowchart illustrating details of a second error correction process of the error correcting unit of FIG. 16.
[FIG. 19] FIG. 19 is a block diagram illustrating details of a fourth configuration example of the error correcting unit of FIG. 2.
[FIG. 20] FIG. 20 is a flowchart illustrating an error correction process of the error correcting unit of FIG. 19.
[FIG. 21] FIG. 21 is a flowchart illustrating details of a third error correction process of FIG. 20.
[FIG. 22] FIG. 22 is a block diagram illustrating a fifth configuration example of the error correcting unit of FIG. 2.
[FIG. 23] FIG. 23 is a flowchart illustrating an error correction process of the error correcting unit of FIG. 22.
[FIG. 24] FIG. 24 is a block diagram illustrating a configuration example of hardware of a computer.

### Description of Embodiments

### <An embodiment>

### [Configuration example of an embodiment of receiving device]

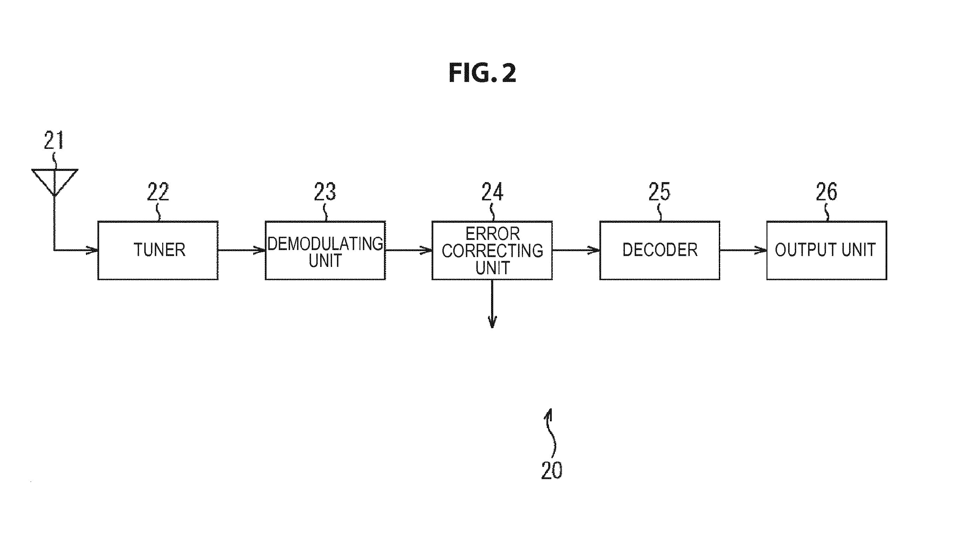

FIG. 2 is a block diagram illustrating a configuration example of an embodiment of a receiving device to which the present disclosure is applied.

A receiving device 20 of FIG. 2 is a receiving device compliant with, for example, an ISDB-T standard, and includes an antenna 21, a tuner 22, a demodulating unit 23, an error correcting unit 24, a decoder 25, and an output unit 26. The receiving device 20 receives and decodes an RF signal of terrestrial digital broadcasting compliant with the ISDB-T standard.

Specifically, the antenna 21 serves as a receiving unit. The antenna 21 receives an RF signal transmitted from a transmission device such as a broadcasting station (not illustrated) through a propagation path and provides the signal to the tuner 22.

The tuner 22 performs frequency conversion on the RF signal received by the antenna 21. An IF signal obtained by performing frequency conversion on the RF signal is provided to the demodulating unit 23.

The demodulating unit 23 performs A/D conversion on the IF signal provided from the tuner 22 and then performs multi-value demodulation and de-map processing so that a likelihood is generated. The demodulating unit 23 provides the likelihood to the error correcting unit 24 as encoded data that is encoded by an external code and an internal code.

The error correcting unit 24 performs an error correction process on the likelihood provided from the demodulating unit 23 and provides data obtained as a result to the decoder 25. In addition, the error correcting unit 24 outputs the number of bit errors for each predetermined period to the outside.

The decoder 25 decodes the data provided from the error correcting unit 24 using, for example, a scheme of a Moving Picture Experts Group (MPEG) phase, and provides image or sound data obtained as a result to the output unit 26.

The output unit 26 includes a display device, a speaker, and the like. The display device displays an image corresponding to the image data provided from the decoder 25, and the speaker outputs sound corresponding to the sound data.

### [First configuration example of error correcting unit]

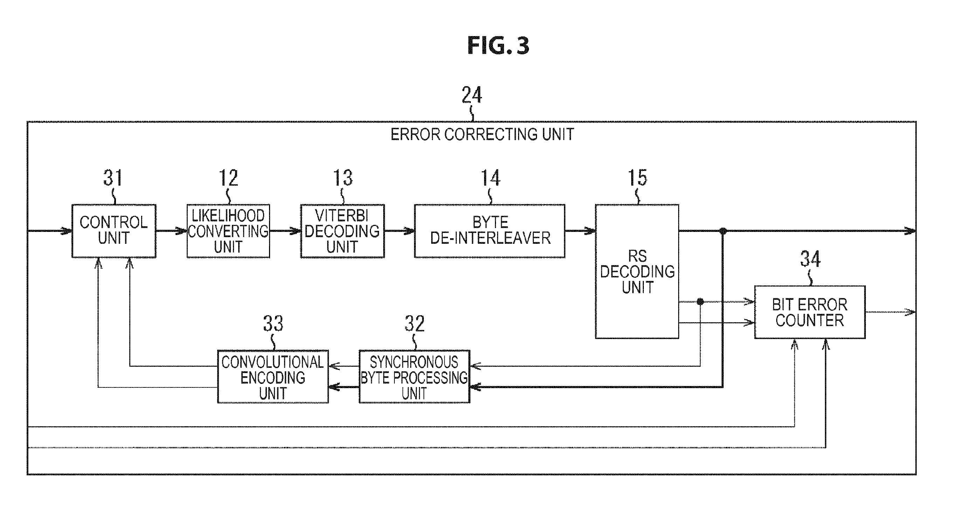

FIG. 3 is a block diagram illustrating a first configuration example of the error correcting unit 24 of FIG. 2.

Components illustrated in FIG. 3 that are the same as those in FIG. 1 are denoted by the same reference numerals. Redundant description will be appropriately omitted.

A configuration of the error correcting unit 24 of FIG. 3 is mainly different from the configuration of FIG. 1 in that a control unit 31 and a convolutional encoding unit 33 are provided instead of the control unit 11 and the convolutional encoding unit 17, a synchronous byte processing unit 32 and a bit error counter 34 are provided, and the byte interleaver 16 is not provided. The error correcting unit 24 of FIG. 3 converts the likelihood using only a decoding result that has passed through a zero delay branch in the byte de-interleaver 14.

Specifically, the control unit 31 of the error correcting unit 24 includes a built-in memory and temporarily stores the likelihood as encoded data provided from the demodulating unit 23 of FIG. 2. Then, when the likelihood of a predetermined unit (for example, in units of packets) is stored in the built-in memory, the control unit 31 performs first reading of the likelihood of the unit and provides the result to the likelihood converting unit 12. In this case, the control unit 31 provides a predetermined value as an encoding bit and reliability information of the L level to the likelihood converting unit 12.

In addition, when the reliability information and the encoding bit are output from the convolutional encoding unit 33, the control unit 31 performs second reading of the likelihood of the predetermined unit and provides the result to the likelihood converting unit 12. In this case, when the reliability information and the encoding bit provided from the convolutional encoding unit 33 correspond to a decoding result that has passed through a zero delay branch in the byte de-interleaver 14, the control unit 31 provides the reliability information and the encoding bit to the likelihood converting unit 12.

On the other hand, when the reliability information and the encoding bit provided from the convolutional encoding unit 33 correspond to a decoding result that has passed through a branch other than the zero delay branch in the byte de-interleaver 14, the control unit 31 provides a predetermined value as the encoding bit and reliability information of the L level to the likelihood converting unit 12.

As described above, the encoding bit and the reliability information corresponding to the decoding result that has passed through the zero delay branch are directly provided to the likelihood converting unit 12. Accordingly, when the level of reliability information is an H level, the likelihood converting unit 12 use the encoding bit and the reliability information to convert the likelihood into a likelihood that is closest to the encoding bit, thereby increasing reliability of the decoding result.

In other words, based on the decoding result that has passed through the zero delay branch, that is, the encoding bit and the reliability information corresponding to the decoding result that is not delayed by the byte de-interleaver 14, the likelihood converting unit 12 converts the likelihood corresponding to the decoding result. Then, the likelihood converting unit 12 provides the converted likelihood to the Viterbi decoding unit 13, controls the Viterbi decoding unit 13 to decode the converted likelihood, and controls the Viterbi decoding unit 13 to increase reliability of the decoding result.

In addition, the likelihood converting unit 12 is provided with reliability information of the L level as reliability information corresponding to the decoding result that has passed through a branch other than the zero delay branch. Accordingly, in the likelihood corresponding to the decoding result that has passed through a branch other than the zero delay branch, regardless of the decoding result, the likelihood converting unit 12 directly provides the likelihood input from the control unit 31 to the Viterbi decoding unit 13 as the converted likelihood. That is, the likelihood converting unit 12 does not use the encoding bit and the reliability information corresponding to the decoding result that has passed through a branch other than the zero delay branch in order to control the Viterbi decoding unit 13.

The synchronous byte processing unit 32 serves as a replacement unit, and replaces a value of a synchronous byte of bytewise decoded data output from the RS decoding unit 15 with a predetermined value. Specifically, in the ISDB-T standard, a value of a synchronous byte of a packet is a known value 0x47, and a position of a synchronous byte of an RS encoded packet is an end of the packet. Therefore, the synchronous byte processing unit 32 sets the byte of the end position of the decoded data to the synchronous byte and replaces the value of the synchronous byte with the known value 0x47.

In addition, the synchronous byte processing unit 32 replaces the level of the decoding success flag of the synchronous byte out of the decoding success flag output from the RS decoding unit 15 with the H level. Then, the synchronous byte processing unit 32 provides the replaced bytewise decoded data and decoding success flag to the convolutional encoding unit 33.

Similar to the convolutional encoding unit 17 of FIG. 1, based on the bytewise decoded data provided from the synchronous byte processing unit 32, the convolutional encoding unit 33 performs convolutional coding by generating the encoding bit. In addition, similar to the convolutional encoding unit 17, the convolutional encoding unit 33 generates reliability information based on the decoding success flag. Then, the convolutional encoding unit 33 provides the encoding bit and the reliability information to the control unit 31.

The bit error counter 34 serves as a calculating unit. The bit error counter 34 accumulates the number of error bits based on the decoding success flag that is output from the RS decoding unit 15 and corresponds to the likelihood on which first reading has been performed by the control unit 31 and the number of corrected bits as well as a fixed number of error bits serving as a fixed value of the number of error bits and a period for measuring the number of bit errors input from the outside.

Specifically, when the level of the decoding success flag is the H level, the bit error counter 34 accumulates the number of corrected bits within the period for measuring the number of bit errors. On the other hand, when the level of the decoding success flag is the L level, the bit error counter 34 accumulates the fixed number of error bits within the period for measuring the number of bit errors. The bit error counter 34 outputs the number of accumulated bits for each period for measuring the number of bit errors to the outside as the number of bit errors.

### [Configuration example of likelihood converting unit]

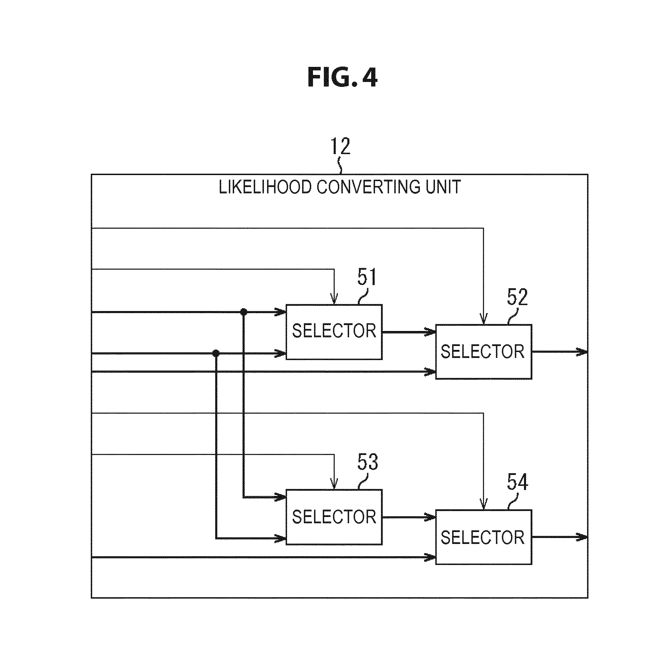

FIG. 4 is a block diagram illustrating a configuration example of the likelihood converting unit 12 of FIG. 3.

The likelihood converting unit 12 of FIG. 4 includes selectors 51 to 54.

The selector 51 of the likelihood converting unit 12 selects a likelihood that is closest to 1 or a likelihood that is closest to zero input from the outside based on an encoding bit #1 provided from the control unit 31 of FIG. 3. Specifically, the selector 51 selects the likelihood that is closest to 1 when the encoding bit #1 is 1 and selects the likelihood that is closest to 0 when the encoding bit #1 is 0. The selector 51 provides the selected likelihood to the selector 52.

The selector 52 selects the likelihood provided from the selector 51 or the likelihood provided from the control unit 31 based on reliability information #1 provided from the control unit 31. Specifically, the selector 52 selects the likelihood provided from the selector 51 when the level of the reliability information #1 is the H level and selects the likelihood provided from the control unit 31 when the level of the reliability information #1 is the L level. The selector 52 provides the selected likelihood to the Viterbi decoding unit 13 of FIG. 3 as the converted likelihood.

Similar to the selector 51, the selector 53 selects the likelihood that is closest to 1 or the likelihood that is closest to 0 input from the outside based on an encoding bit #2 provided from the control unit 31. The selector 53 provides the selected likelihood to the selector 54.

Similar to the selector 52, the selector 54 selects the likelihood provided from the selector 53 or the likelihood provided from the control unit 31 based on the reliability information #2 provided from the control unit 31. The selector 54 provides the selected likelihood to the Viterbi decoding unit 13 as the converted likelihood.

### [Configuration example of convolutional encoding unit]

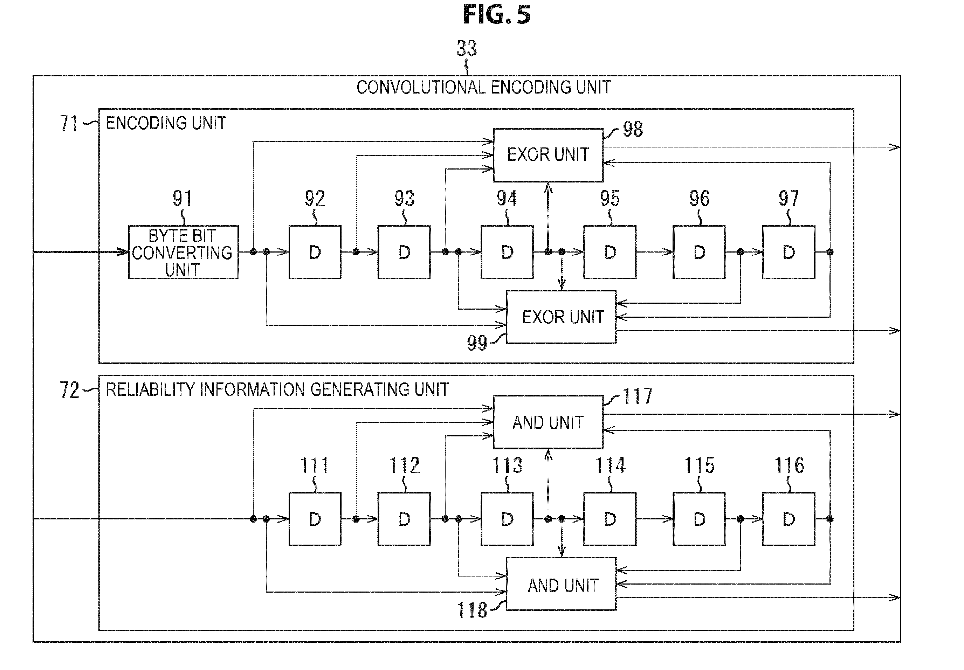

FIG. 5 is a block diagram illustrating a configuration example of the convolutional encoding unit 33 of FIG. 3.

The convolutional encoding unit 33 of FIG. 5 includes an encoding unit 71 and a reliability information generating unit 72.

The encoding unit 71 includes a byte bit converting unit 91, delay units 92 to 97, an EXOR unit 98, and an EXOR unit 99.

The byte bit converting unit 91 of the encoding unit 71 converts the bytewise decoded data provided from the synchronous byte processing unit 32 of FIG. 3 into bitwise data and provides the bitwise decoded data to the delay unit 92, the EXOR unit 98, and the EXOR unit 99.

When the bitwise decoded data is input from the byte bit converting unit 91, the delay unit 92 provides the maintained decoded data to the delay unit 93 and the EXOR unit 98 and maintains the input decoded data. When the bitwise decoded data is input from the delay unit 92, the delay unit 93 provides the maintained decoded data to the delay unit 94, the EXOR unit 98, and the EXOR unit 99 and maintains the input decoded data.

When the bitwise decoded data is input from the delay unit 93, the delay unit 94 provides the maintained decoded data to the delay unit 95, the EXOR unit 98, and the EXOR unit 99 and maintains the input decoded data. When the bitwise decoded data is input from the delay unit 94, the delay unit 95 provides the maintained decoded data to the delay unit 96 and maintains the input decoded data.

When the bitwise decoded data is input from the delay unit 95, the delay unit 96 provides the maintained decoded data to the delay unit 97 and the EXOR unit 99 and maintains the input decoded data. When the bitwise decoded data is input from the delay unit 96, the delay unit 97 provides the maintained decoded data to the EXOR unit 98 and the EXOR unit 99 and maintains the input decoded data.

The EXOR unit 98 computes exclusive OR of the bitwise decoded data provided from the byte bit converting unit 91, the delay units 92 to 94, and the delay unit 97, and provides the computation result to the control unit 31 of FIG. 3 as the encoding bit #1.

The EXOR unit 99 computes exclusive OR of the bitwise decoded data provided from the byte bit converting unit 91, the delay unit 93, the delay unit 94, the delay unit 96, and the delay unit 97, and provides the computation result to the control unit 31 as the encoding bit #2.

The reliability information generating unit 72 includes delay units 111 to 116, an AND unit 117, and an AND unit 118.

When the decoding success flag is input from the synchronous byte processing unit 32, the delay unit 111 provides the maintained decoding success flag to the delay unit 112 and the AND unit 117 and maintains the input decoding success flag. When the decoding success flag is input from the delay unit 111, the delay unit 112 provides the maintained decoding success flag to the delay unit 113, the AND unit 117, and the AND unit 118 and maintains the input decoding success flag.

When the decoding success flag is input from the delay unit 112, the delay unit 113 provides the maintained decoding success flag to the delay unit 114, the AND unit 117, and the AND unit 118 and maintains the input decoding success flag. When the decoding success flag is input from the delay unit 113, the delay unit 114 provides the maintained decoding success flag to the delay unit 115 and maintains the input decoding success flag.

When the decoding success flag is input from the delay unit 114, the delay unit 115 provides the maintained decoding success flag to the delay unit 116 and the AND unit 118 and maintains the input decoding success flag. When the decoding success flag is input from the delay unit 115, the delay unit 116 provides the maintained decoding success flag to the AND unit 117 and the AND unit 118 and maintains the input decoding success flag.

The AND unit 117 computes a logical sum of the decoding success flag provided from the synchronous byte processing unit 32, the decoding success flag provided from the delay units 111 to 113, and the decoding success flag provided from the delay unit 116, and provides the computation result to the control unit 31 as the reliability information #1.

The AND unit 118 computes a logical sum of the decoding success flag provided from the synchronous byte processing unit 32 as well as the decoding success flag provided from the delay unit 112, the delay unit 113, the delay unit 115, and the delay unit 116, and provides the computation result to the control unit 31 as the reliability information #2.

### [Description of process of error correcting unit of FIG. 3]

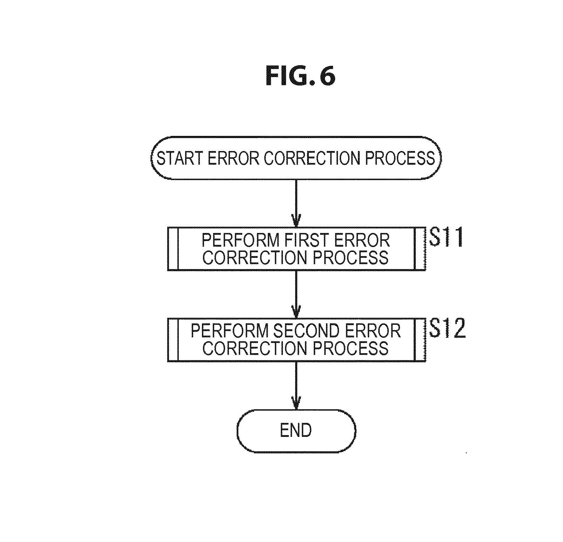

FIG. 6 is a flowchart illustrating an error correction process of the error correcting unit 24 of FIG. 3. The error correction process starts, for example, whenever a likelihood of one packet is input from the demodulating unit 23 of FIG. 2 and stored in the control unit 31.

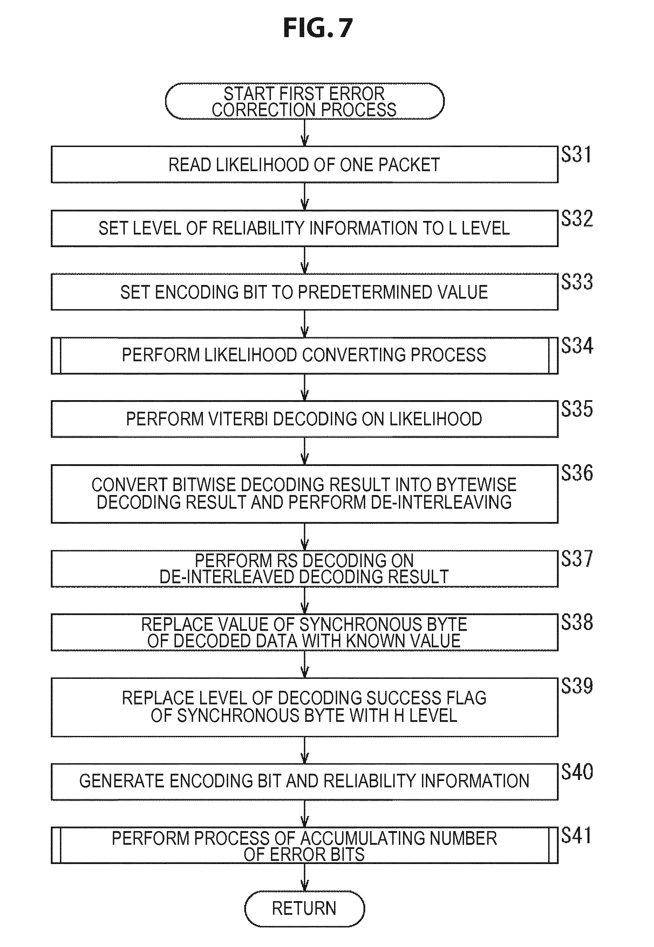

In step S11 of FIG. 6, the error correcting unit 24 of FIG. 3 performs a first error correction process that is a first error correction process of the likelihood of one packet. Details of the first error correction process will be described with reference to the following FIG. 7.

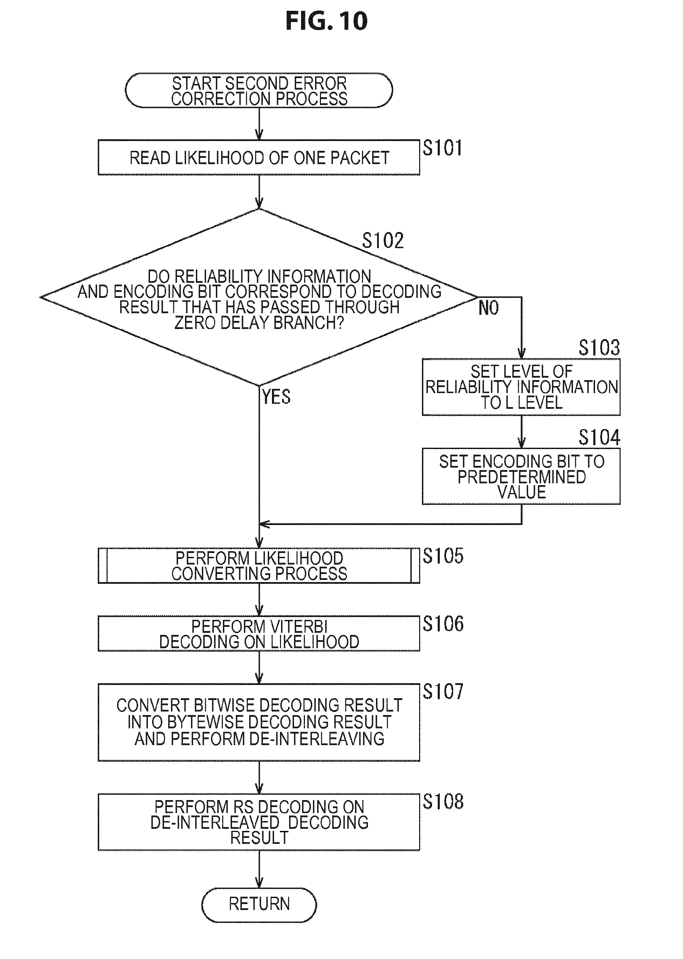

In step S12, the error correcting unit 24 performs a second error correction process that is a second error correction process of the likelihood of one packet. Details of the second error correction process will be described below with reference to FIG. 10. After the second error correction process, the error correction process is terminated.

FIG. 7 is a flowchart illustrating details of the first error correction process of step S11 of FIG. 6.

In step S31 of FIG. 7, the control unit 31 of the error correcting unit 24 reads the likelihood of one packet stored in the built-in memory and provides the likelihood to the likelihood converting unit 12. In step S32, the control unit 31 sets the level of the reliability information to the L level and provides the level to the likelihood converting unit 12.

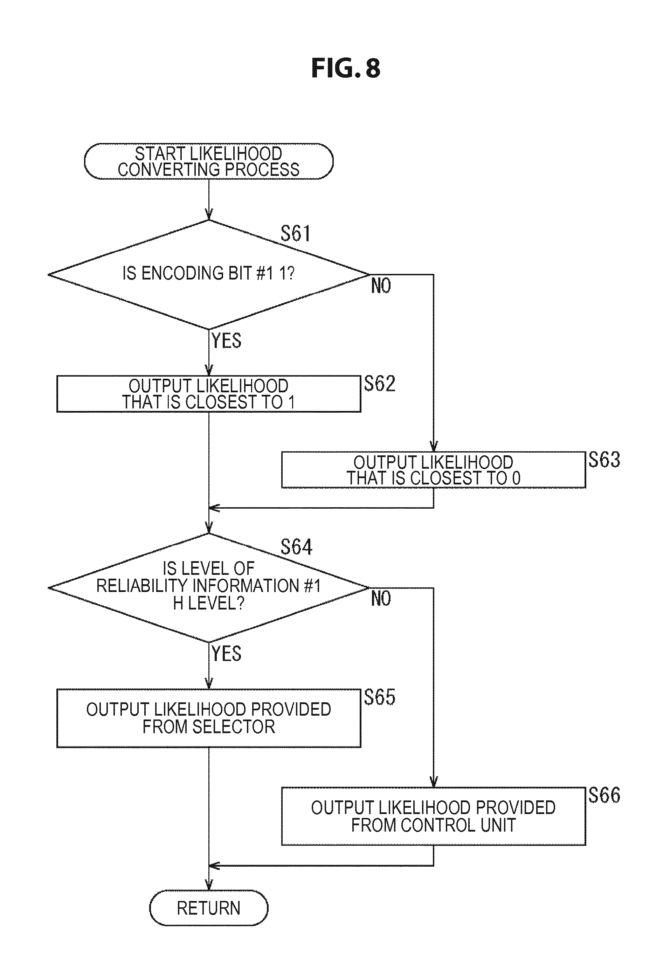

In step S33, the control unit 31 sets the encoding bit to a predetermined value and provides the value to the likelihood converting unit 12. In step S34, the likelihood converting unit 12 performs a likelihood converting process of converting the likelihood based on the reliability information and the encoding bit provided from the control unit 31. Details of the likelihood converting process will be described with reference to the following FIG. 8.

In step S35, the Viterbi decoding unit 13 performs Viterbi decoding on the likelihood provided from the likelihood converting unit 12 and provides the bitwise decoding result to the byte de-interleaver 14. In step S36, the byte de-interleaver 14 converts the bitwise decoding result provided from the Viterbi decoding unit 13 into the bytewise decoding result and performs de-interleaving. The byte de-interleaver 14 provides the de-interleaved bytewise decoding result to the RS decoding unit 15.

In step S37, the RS decoding unit 15 performs RS decoding on the de-interleaved bytewise decoding result provided from the byte de-interleaver 14, outputs the decoded data obtained as a result, and provides the result to the synchronous byte processing unit 32. In addition, the RS decoding unit 15 provides the decoding success flag obtained as a result of the RS decoding to the synchronous byte processing unit 32 and the bit error counter 34, and provides the number of corrected bits obtained as a result of RS decoding to the bit error counter 34.

In step S38, the synchronous byte processing unit 32 replaces a synchronous byte of the bytewise decoded data provided from the RS decoding unit 15 with the known value 0x47, and provides the value to the convolutional encoding unit 33. In step S39, the synchronous byte processing unit 32 replaces the level of the decoding success flag of the synchronous byte of the decoding success flag provided from the RS decoding unit 15 with the H level, and provides the level to the convolutional encoding unit 33.

In step S40, the convolutional encoding unit 33 performs convolutional coding by generating the encoding bit based on the bytewise decoded data provided from the synchronous byte processing unit 32 and generates reliability information based on the decoding success flag. Then, the convolutional encoding unit 33 provides the encoding bit and the reliability information to the control unit 31.

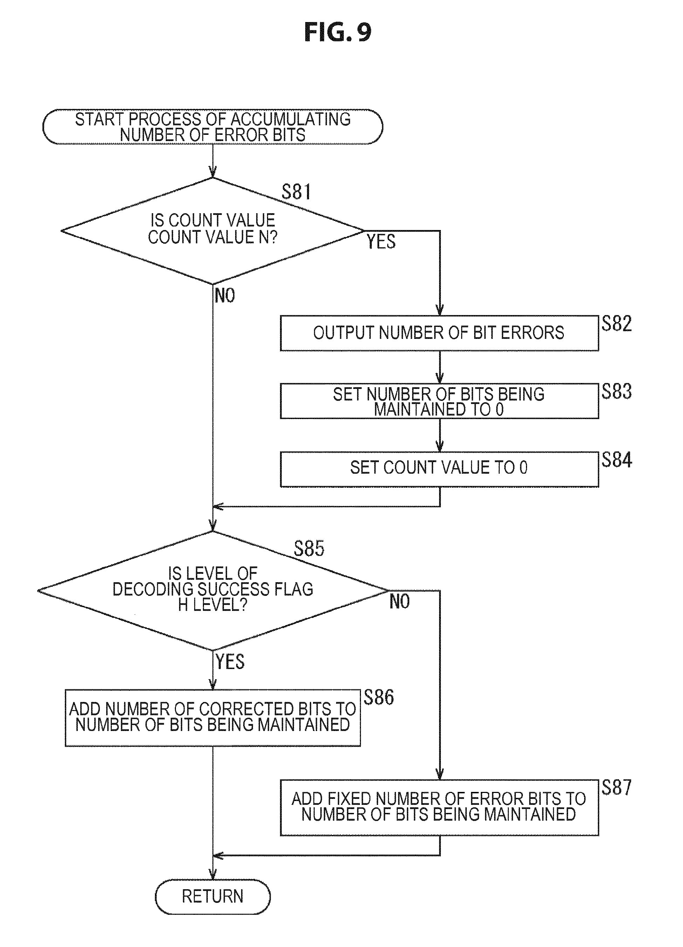

In step S41, the bit error counter 34 performs a process of accumulating the number of error bits in which the number of error bits is accumulated based on the decoding success flag from the RS decoding unit 15 and the number of corrected bits as well as the fixed number of error bits and the period for measuring the number of bit errors input from the outside. Details of the process of accumulating the number of error bits will be described below with reference to FIG. 9. After the process of step S41, the process returns to step S11 of FIG. 6 and advances to step S12.

FIG. 8 is a flowchart illustrating details of the likelihood converting process of step S34 of FIG. 7. In FIG. 8, the likelihood converting process of the likelihood #1 is described, but the likelihood converting process of the likelihood #2 is performed in the same manner.

In step S61 of FIG. 8, the selector 51 (FIG. 4) of the likelihood converting unit 12 determines whether the encoding bit #1 provided from the control unit 31 is 1. When it is determined in step S61 that the encoding bit #1 is 1, the selector 51 selects the likelihood that is closest to 1 input from the outside and outputs the likelihood to the selector 52 in step S62. Then, the process advances to step S64.

On the other hand, when it is determined in step S61 that the encoding bit #1 is not 1, that is, when the encoding bit #1 is 0, the selector 51 selects the likelihood that is closest to 0 input from the outside and outputs the likelihood to the selector 52 in step S63. Then, the process advances to step S64.

In step S64, the selector 52 determines whether the level of the reliability information #1 provided from the control unit 31 is the H level. When it is determined in step S64 that the level of the reliability information #1 is the H level, the selector 52 selects the likelihood provided from the selector 51 and outputs the likelihood to the Viterbi decoding unit 13 of FIG. 3 as a converted likelihood #1 in step S65. Then, the process returns to step S34 of FIG. 7 and advances to step S35.

On the other hand, when it is determined in step S64 that the level of the reliability information #1 is not the H level, that is, when the level of the reliability information #1 is the L level, the process advances to step S66. In step S66, the selector 52 selects the likelihood provided from the control unit 31 and outputs the likelihood to the Viterbi decoding unit 13 as the converted likelihood #1. Then, the process returns to step S34 of FIG. 7 and advances to step S35.

FIG. 9 is a flowchart illustrating details of the process of accumulating the number of error bits of step S41 of FIG. 7.

In step S81 of FIG. 9, the bit error counter 34 determines whether a count value of a built-in timer is a count value N corresponding to the period for measuring the number of bit errors. When it is determined in step S81 that the count value is not the count value N, the process advances to step S85.

On the other hand, when it is determined in step S81 that the count value is the count value N, the bit error counter 34 outputs the number of accumulated bits being maintained to the outside as the number of bit errors in step S82.

In step S83, the bit error counter 34 sets the number of bits being maintained to 0. In step S84, the bit error counter 34 sets the count value of the built-in timer to 0, and the process advances to step S85.

In step S85, the bit error counter 34 determines whether the level of the decoding success flag provided from the RS decoding unit 15 is the H level. When it is determined in step S85 that the level of the decoding success flag is the H level, the process advances to step S86.

In step S86, the bit error counter 34 accumulates the number of bits by adding the number of corrected bits provided from the RS decoding unit 15 to the number of bits being maintained. Then, the process returns to step S41 of FIG. 7 and advances to step S12 of FIG. 6.

On the other hand, when it is determined in step S85 that the level of the decoding success flag is the L level, the bit error counter 34 accumulates the number of bits by adding the fixed number of error bits to the number of bits being maintained in step S87. Then, the process returns to step S41 of FIG. 7 and advances to step S12 of FIG. 6.

FIG. 10 is a flowchart illustrating details of the second error correction process of step S12 of FIG. 6.

In step S101 of FIG. 10, the control unit 31 reads the likelihood of one packet stored in the built-in memory again and provides the likelihood to the likelihood converting unit 12. Further, the following process of steps S102 to S104 is performed for each piece of reliability information and encoding bit.

In step S102, the control unit 31 determines whether the reliability information and the encoding bit provided from the convolutional encoding unit 33 correspond to the decoding result that has passed through the zero delay branch in the byte de-interleaver 14.

When it is determined in step S102 that the reliability information and the encoding bit do not correspond to the decoding result that has passed through the zero delay branch in the byte de-interleaver 14, the process advances to step S103.

In step S103, the control unit 31 sets the level of the reliability information to the L level and provides the level to the likelihood converting unit 12. In step S104, the control unit 31 sets the encoding bit to a predetermined value and provides the value to the likelihood converting unit 12. The process advances to step S105.

On the other hand, when it is determined in step S102 that the reliability information and the encoding bit correspond to the decoding result that has passed through the zero delay branch in the byte de-interleaver 14, the control unit 31 provides the reliability information and the encoding bit to the likelihood converting unit 12. Then, the process advances to step S105.

Since the process of steps S105 to S107 is the same as the process of steps S34 to S36 of FIG. 7, descriptions thereof will not be provided.

In step S108, the RS decoding unit 15 performs RS decoding on the de-interleaved bytewise decoding result provided from the byte de-interleaver 14 and outputs decoded data obtained as a result.

As described above, the error correcting unit 24 of FIG. 3 performs control such that the likelihood is converted based on the decoding result that has passed through the zero delay branch and the converted likelihood is decoded, thereby increasing reliability of the decoding result. Therefore, the error correcting unit 24 need not have the byte interleaver 16 as in the error correcting device 10 of FIG. 1 and may decrease a memory for the error correction process.

In addition, since the error correcting unit 24 of FIG. 3 need not have the byte interleaver 16, a capacity of the memory of the control unit 31 may also be significantly decreased compared to the control unit 11.

That is, in the error correcting device 10 of FIG. 1, since the decoding success flag and the decoded data are delayed by the byte interleaver 16, in order for the reliability information and the encoding bit input to the likelihood converting unit 12 to correspond to the likelihood output from the control unit 11, the control unit 11 should maintain a likelihood of the delay by the byte interleaver 16.

However, since the error correcting unit 24 of FIG. 3 has no byte interleaver 16, the delay caused by the byte interleaver 16 is not generated, and the control unit 31 need not maintain the likelihood of the delay. Accordingly, the capacity of the memory of the control unit 31 keeps only a few packets, and the capacity of the memory of the control unit 31 may be significantly decreased compared to the control unit 11.

In addition, the bit error counter 34 accumulates the number of bit errors based on the decoding success flag and the number of corrected bits obtained by the first decoding. Therefore, it is possible to prevent a bit error rate (BER) corresponding to the number of bit errors from not satisfying conditions specified in the standard.

That is, for example, in a DVB-T standard, there is a test specification that should be satisfied by a receiving device called Nording. Specifically, a Nording test spec v 2.2.1 Task3:18 has a condition that a decrease of a carrier to noise ratio (CNR) corresponding to BER 2×10⁻⁴ after Viterbi decoding by 1 dB in the CNR be BER 2×10⁻³ or less after Viterbi decoding. However, when the number of bit errors is accumulated based on the decoding success flag and the number of corrected bits obtained by final decoding, a curve of the BER corresponding to the number of bit errors becomes sharp and the condition may not be satisfied. Therefore, the bit error counter 34 accumulates the number of bit errors based on the decoding success flag and the number of corrected bits obtained by the first decoding, thereby preventing the BER from not satisfying the condition.

Moreover, the synchronous byte processing unit 32 replaces a value of a synchronous byte of the bytewise decoded data output from the RS decoding unit 15 with a known value and replaces the level of the decoding success flag of the synchronous byte with the H level. Therefore, the convolutional encoding unit 33 is able to generate the more reliable reliability information and encoding bit based on the replaced decoded data and decoding success flag. As a result, it is possible to increase a positive decoding probability when Viterbi decoding is performed.

### [Second configuration example of error correcting unit]

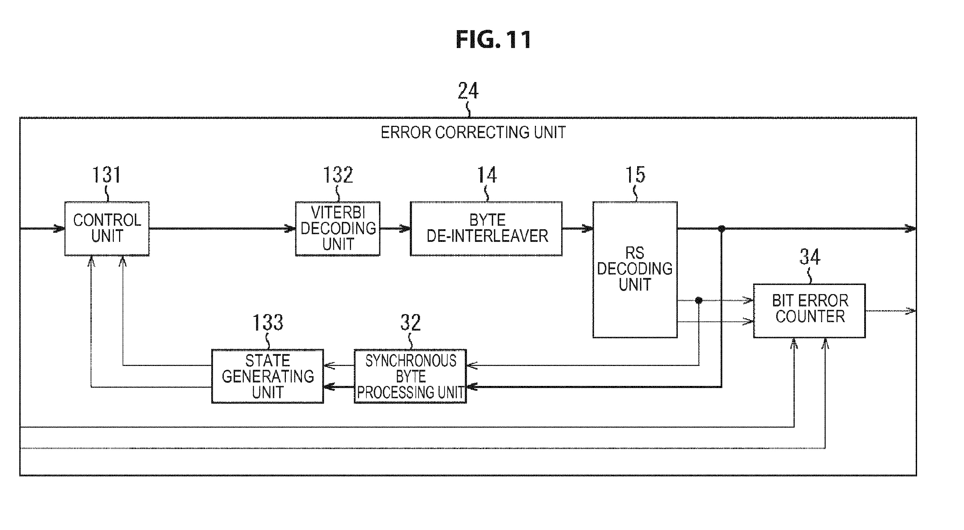

FIG. 11 is a block diagram illustrating a second configuration example of the error correcting unit 24 of FIG. 2.

Components illustrated in FIG. 11 that are the same as those in FIG. 3 are denoted by the same reference numerals. Redundant description will be appropriately omitted.

A configuration of the error correcting unit 24 of FIG. 11 is mainly different from the configuration of FIG. 3 in that a control unit 131, a Viterbi decoding unit 132, and a state generating unit 133 are provided instead of the control unit 31, the Viterbi decoding unit 13, and the convolutional encoding unit 33, and the likelihood converting unit 12 is not provided. The error correcting unit 24 of FIG. 3 performs a termination process of Viterbi decoding based on the decoding result that has passed through the zero delay branch in the byte de-interleaver 14.

Specifically, similar to the control unit 31 of FIG. 3, the control unit 131 includes a built-in memory and temporarily stores the likelihood provided from the demodulating unit 23 of FIG. 2. Also, similar to the control unit 31, the control unit 131 performs first reading of the likelihood and provides the result to the Viterbi decoding unit 132. In this case, the control unit 131 provides a predetermined value as a state and reliability information of the state of the L level to the Viterbi decoding unit 132.

In addition, when the reliability information of the state and the state are output from the state generating unit 133, the control unit 131 performs second reading of the likelihood of the predetermined unit and provides the result to the Viterbi decoding unit 132. In this case, when the reliability information of the state and the state provided from the state generating unit 133 correspond to the decoding result that has passed through the zero delay branch in the byte de-interleaver 14, the control unit 131 provides the reliability information of the state and the state to the Viterbi decoding unit 132.

On the other hand, when the reliability information of the state and the state provided from the state generating unit 133 do not correspond to the decoding result that has passed through the zero delay branch in the byte de-interleaver 14, the control unit 131 provides the predetermined value as the state and the reliability information of the state of the L level to the Viterbi decoding unit 132.

The Viterbi decoding unit 132 performs Viterbi decoding on the likelihood provided from the control unit 131 based on the state and the reliability information of the state provided from the control unit 131.

Here, Viterbi decoding will be described. In Viterbi decoding, first, for each of a state at the current time and state at the immediately preceding time, a state metric of the state at the current time is calculated from a branch metric of branches in a trellis calculated from the likelihood and a state metric of the state at the immediately preceding time. Then, a path (branch) between the state at the immediately preceding time and the state at the current time when a sum of the state metric of the state at the immediately preceding time and the branch metric is minimum is set as a survival path. Then, by tracing the survival path from a certain time, a process called Traceback is performed, and a bitstream (code bit or information bit) assigned to the path (branch) is obtained as the decoding result. In Viterbi decoding, for example, a decoding process is not immediately started, but the decoding process starts when the path merges with an optimal path (maximum likelihood path) after training for a predetermined period.

As described above, the Viterbi decoding unit 132 performs such Viterbi decoding based on the state and the reliability information of the state provided from the control unit 131. Specifically, when the level of the reliability information of the state is the H level, the Viterbi decoding unit 132 performs a termination process of Viterbi decoding such that the state metric of the state provided from the control unit 131 is set to a minimum value and a state metric of other state is set to a maximum value. Then, the Viterbi decoding unit 132 determines the survival path based on the likelihood and the state metric after the termination process, and obtains the bitwise decoding result by performing Traceback using the state provided from the control unit 131 as a start state of Traceback.

In this manner, when the level of the reliability information of the state is the H level, since the Viterbi decoding unit 132 uses the start state of Traceback as the state provided from the control unit 131, it is possible to start Traceback from a state having a minimum state metric without a circuit for comparing the state metrics. By starting Traceback from the state having the minimum state metric, the state is highly likely to be along the optimal path from a start time of Traceback.

On the other hand, when the level of the reliability information of the state is the L level, the Viterbi decoding unit 132 performs normal Viterbi decoding on the likelihood and obtains the bitwise decoding result. The Viterbi decoding unit 132 provides the bitwise decoding result to the byte de-interleaver 14.

The state generating unit 133 generates the state and the reliability information of the state based on the bytewise decoded data and decoding success flag provided from the synchronous byte processing unit 32. Then, the state generating unit 133 provides the state and the reliability information of the state to the control unit 131.

Here, as described above, the Viterbi decoding unit 132 is provided with the state and the reliability information of the state corresponding to the decoding result that has passed through the zero delay branch without change. That is, by the state generating unit 133, the state and the reliability information of the state determined based on the bytewise decoded data and decoding success flag corresponding to the decoding result that has passed through the zero delay branch are provided to the Viterbi decoding unit 132 without change. Therefore, when the level of the reliability information of the state is the H level, the Viterbi decoding unit 132 performs a termination process of the state, thereby increasing reliability of the decoding result.

Therefore, the state generating unit 133 determines the state and the reliability information of the state based on the decoded data and the decoding success flag corresponding to the decoding result that has passed through the zero delay branch, and provides the result to the control unit 131. When the Viterbi decoding unit 132 performs a termination process of the state in which the level of the reliability information is the H level, it may be considered that the Viterbi decoding unit 132 is controlled to increase reliability of the decoding result.

On the other hand, as described above, the Viterbi decoding unit 132 is provided with reliability information of the L level as reliability information corresponding to the decoding result that has passed through a branch other than the zero delay branch. Accordingly, the Viterbi decoding unit 132 does not perform the termination process. Therefore, the state generating unit 133 may be considered not to use the state and the reliability information of the state corresponding to the decoding result that has passed through a branch other than the zero delay branch in order to control the Viterbi decoding unit 132.

### [Configuration example of state generating unit]

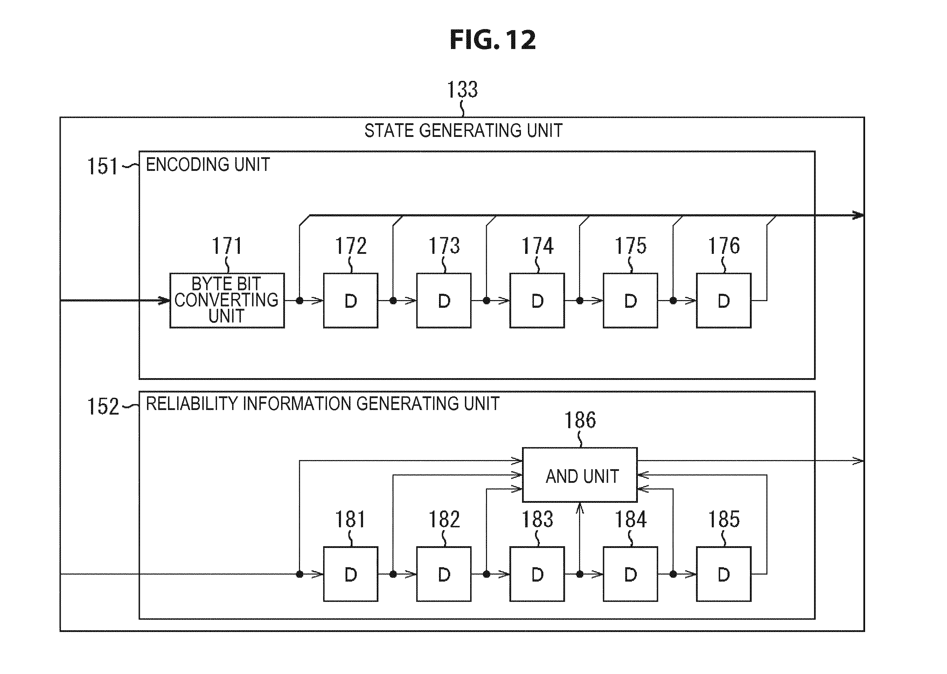

FIG. 12 is a block diagram illustrating a configuration example of the state generating unit 133 of FIG. 11.

The state generating unit 133 of FIG. 12 includes an encoding unit 151 and a reliability information generating unit 152.

The encoding unit 151 of the state generating unit 133 includes a byte bit converting unit 171 and delay units 172 to 176.

The byte bit converting unit 171 converts the bytewise decoded data provided from the synchronous byte processing unit 32 of FIG. 11 into the bitwise decoded data, provides the result to the control unit 131 as a state of one bit and also provides the result the delay unit 172.

The delay units 172 to 176 are sequentially connected in series. When the bitwise decoded data is input from the byte bit converting unit 171, the delay unit 172 provides the maintained decoded data to the control unit 131 as the state of one bit and also provides the data to the delay unit 173. Then, the delay unit 172 maintains the input bitwise decoded data.

Similar to the delay unit 172, when the bitwise decoded data is input from the delay unit of a front-stage, the delay units 173 to 176 provide the maintained decoded data to the control unit 131 as the state of one bit and also provide the data to the delay unit of a rear-stage. Then, similar to the delay unit 172, the delay units 173 to 176 maintain the input bitwise decoded data.

Accordingly, the encoding unit 151 provides 6-bit decoded data to the control unit 131 as the state.

The reliability information generating unit 152 includes delay units 181 to 185 and an AND unit 186.

The delay units 181 to 185 are sequentially connected in series. When the decoding success flag is input from the synchronous byte processing unit 32 of FIG. 11, the delay unit 181 provides the maintained decoding success flag to the AND unit 186 and the delay unit 182. Then, the delay unit 181 maintains the input decoding success flag.

Similar to the delay unit 181, when the decoding success flag is input from the delay unit of the front-stage, the delay units 182 to 185 provide the maintained decoding success flag to the AND unit 186 and the delay unit of the rear-stage. Then, similar to the delay unit 181, the delay units 182 to 185 maintain the input decoding success flag.

The AND unit 186 computes a logical sum of the decoding success flags provided from the synchronous byte processing unit 32 and the delay units 181 to 185 and provides the logical sum obtained as a result to the control unit 131 as the reliability information of the state.

### [Description of process of error correcting unit of FIG. 11]

Similar to the error correction process of FIG. 6, in the error correction process of the error correcting unit 24 of FIG. 11, a first error correction process and a second error correction process are sequentially performed.

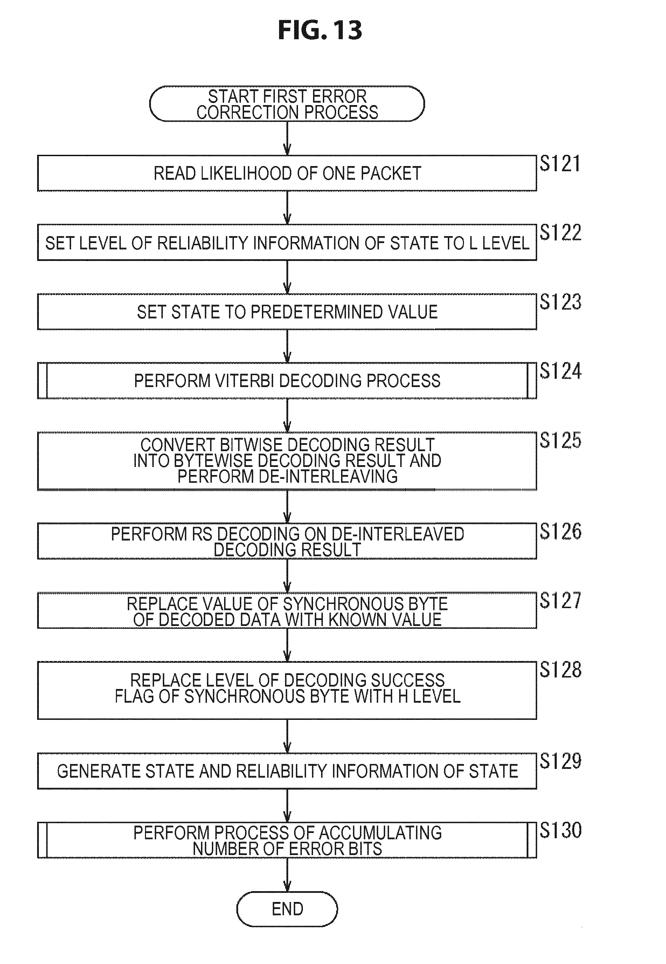

FIG. 13 is a flowchart illustrating details of the first error correction process of the error correcting unit 24 of FIG. 11.

In step S121 of FIG. 13, the control unit 131 of the error correcting unit 24 reads the likelihood of one packet stored in the built-in memory and provides the likelihood to the Viterbi decoding unit 132. In step S122, the control unit 131 sets the level of the reliability information of the state to the L level and provides the level to the Viterbi decoding unit 132.

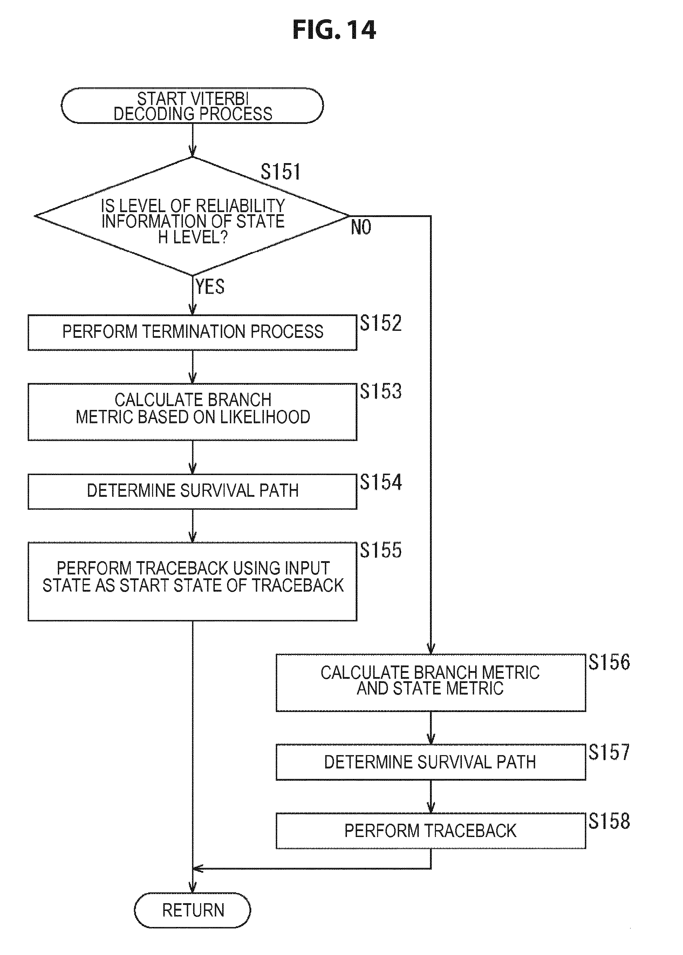

In step S123, the control unit 131 sets the state to a predetermined value and provides the value to the Viterbi decoding unit 132. In step S124, the Viterbi decoding unit 132 performs a Viterbi decoding process in which Viterbi decoding of the likelihood is performed based on the state and the reliability information of the state provided from the control unit 131. Details of the Viterbi decoding process will be described with reference to the following FIG. 14.

Since the process of steps S125 to S128 is the same as the process of steps S36 to S39 of FIG. 7, descriptions thereof will not be provided.

In step S129, the state generating unit 133 generates the state and the reliability information of the state based on the bytewise decoded data and decoding success flag provided from the synchronous byte processing unit 32. Then, the state generating unit 133 provides the state and the reliability information of the state to the control unit 131.

In step S130, the bit error counter 34 performs the process of accumulating the number of error bits of FIG. 9 and terminates the first error correction process.

FIG. 14 is a flowchart illustrating details of the Viterbi decoding process of step S124 of FIG. 13.

In step S151 of FIG. 14, the Viterbi decoding unit 132 determines whether the level of the reliability information of the state provided from the control unit 131 is the H level. When it is determined in step S151 that the level of the reliability information is the H level, the Viterbi decoding unit 132 performs a termination process of the state provided from the control unit 131 in step S152.

In step S153, the Viterbi decoding unit 132 calculates the branch metric for each of the state at the current time and the state at the immediately preceding time based on the likelihood provided from the control unit 131. In step S154, the Viterbi decoding unit 132 determines the survival path based on the calculated branch metric and the state metric after the termination process.

In step S155, the Viterbi decoding unit 132 performs Traceback using the state input from the control unit 131 as the start state of Traceback. The Viterbi decoding unit 132 provides the bitwise decoding result obtained as a result to the byte de-interleaver 14. After the process of step S155, the process returns to step S124 of FIG. 13 and advances to step S125.

On the other hand, when it is determined in step S151 that the level of the reliability information is not the H level, that is, when the level of the reliability information is the L level, the process advances to step S156. In step S156, for each of the state at the current time and the state at the immediately preceding time, the Viterbi decoding unit 132 calculates the branch metric based on the likelihood and calculates the state metric at the current time from the branch metric and the state metric at the immediately preceding time.

In step S157, the Viterbi decoding unit 132 determines a path between the state at the immediately preceding time and the state at the current time when a sum of the state metric of the state at the immediately preceding time and the branch metric is minimum as the survival path.

In step S158, the Viterbi decoding unit 132 performs Traceback using a predetermined state as the start state. The Viterbi decoding unit 132 provides the bitwise decoding result obtained as a result to the byte de-interleaver 14. After the process of step S158, the process returns to step S124 of FIG. 13 and advances to step S125.

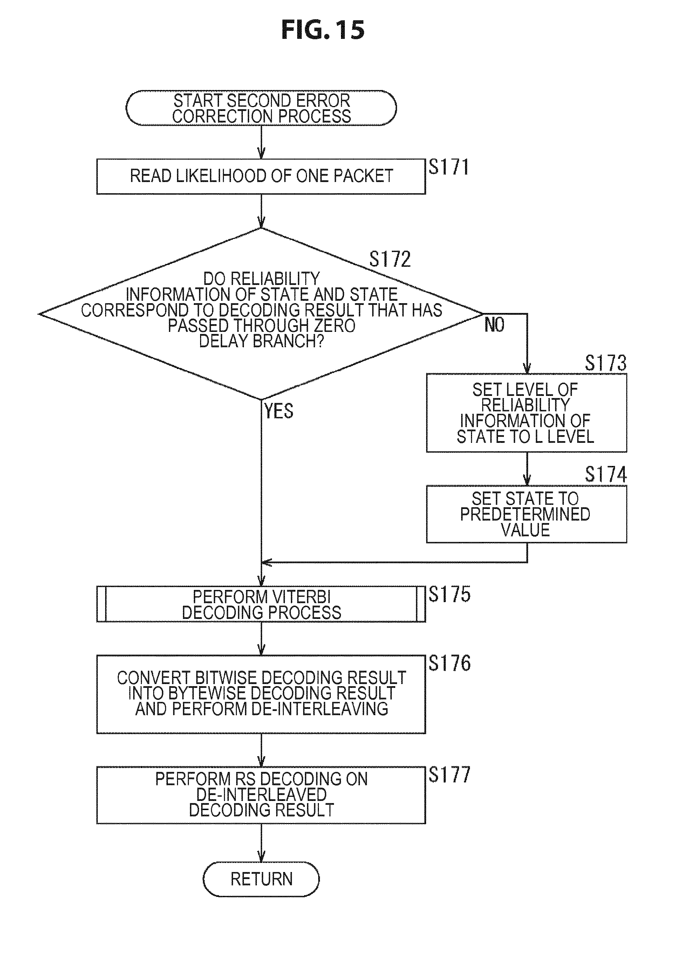

FIG. 15 is a flowchart illustrating details of the second error correction process of the error correcting unit 24 of FIG. 11.

In step S171 of FIG. 15, the control unit 131 reads the likelihood of one packet stored in the built-in memory again and provides the likelihood to the Viterbi decoding unit 132. Further, the following process of steps S172 to S174 is performed for each of the reliability information of the state and the state.

In step S172, the control unit 131 determines whether the reliability information of the state and the state provided from the state generating unit 133 correspond to the decoding result that has passed through the zero delay branch in the byte de-interleaver 14.

When it is determined in step S172 that the reliability information of the state and the state do not correspond to the decoding result that has passed through the zero delay branch in the byte de-interleaver 14, the process advances to step S173.

In step S173, the control unit 131 sets the level of the reliability information of the state to the L level and provides the level to the Viterbi decoding unit 132. In step S174, the control unit 131 sets the state to a predetermined value and provides the value to the Viterbi decoding unit 132, and the process advances to step S175.

On the other hand, when it is determined in step S172 that the reliability information of the state and the state correspond to the decoding result that has passed through the zero delay branch in the byte de-interleaver 14, the control unit 131 provides the reliability information of the state and the state to the Viterbi decoding unit 132. Then, the process advances to step S175.

Since the process of steps S175 to S177 is the same as the process of steps S124 to S126 of FIG. 13, descriptions thereof will not be provided. After the process of step S177, the second error correction process is terminated.

As described above, the error correcting unit 24 of FIG. 11 determines the state in which the level of the reliability information is the H level based on the decoding result that has passed through the zero delay branch and allows a termination process of the state to be performed by the Viterbi decoding unit 132. Accordingly, compared to the error correcting unit 24 of FIG. 3, it is possible to increase reliability of the decoding result. In addition, similar to the error correcting unit 24 of FIG. 3, the byte interleaver 16 need not be included, and a capacity of the memory of the control unit 131 may also be significantly decreased.

### [Third configuration example of error correcting unit]

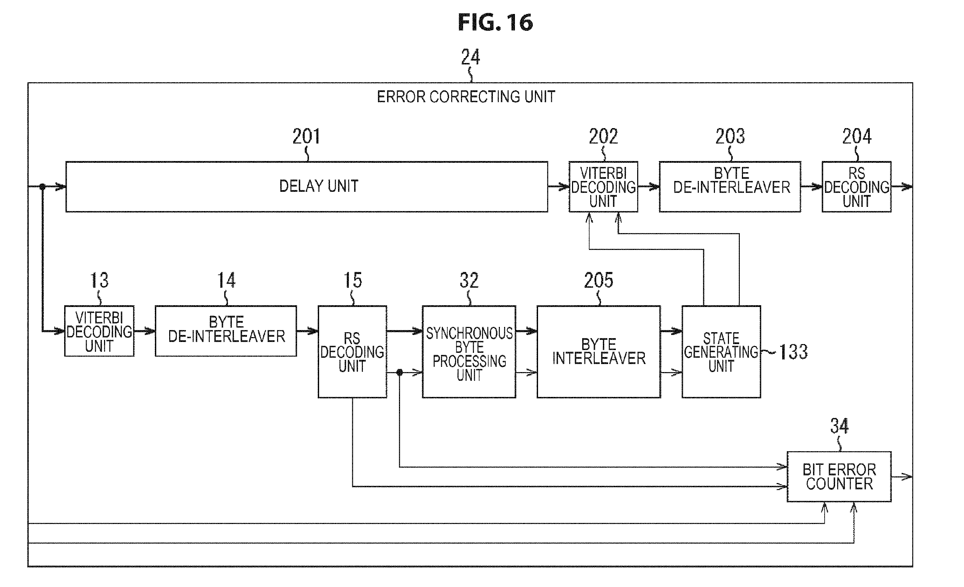

FIG. 16 is a block diagram illustrating a third configuration example of the error correcting unit 24 of FIG. 2.

Components illustrated in FIG. 16 that are the same as those in FIG. 3 or FIG. 11 are denoted by the same reference numerals. Redundant description will be appropriately omitted. The error correcting unit 24 of FIG. 16 performs a termination process of Viterbi decoding based on all decoding results.

Specifically, a delay unit 201, a Viterbi decoding unit 202, a byte de-interleaver 203, and an RS decoding unit 204 of the error correcting unit 24 perform the second error correction process.

More specifically, the delay unit 201 performs a delay by maintaining the likelihood provided from the demodulating unit 23 of FIG. 2 in a predetermined unit (for example, in units of packets). Specifically, the delay unit 201 delays the likelihood by outputting the likelihood corresponding to the state and the reliability information to the Viterbi decoding unit 202 when the state and the reliability information of the state are provided from the state generating unit 133 to the Viterbi decoding unit 202. The delay unit 201 provides the likelihood of the predetermined unit after delay to the Viterbi decoding unit 202.

Similar to the Viterbi decoding unit 132 of FIG. 11, the Viterbi decoding unit 202 performs Viterbi decoding on the likelihood provided from the delay unit 201 based on the reliability information of the state and the state obtained as a result of the first error correction process provided from the state generating unit 133. The Viterbi decoding unit 202 provides the bitwise decoding result obtained as a result to the byte de-interleaver 203.

The byte de-interleaver 203 has the same configuration as the byte de-interleaver 14. Similar to the byte de-interleaver 14, the byte de-interleaver 203 converts the bitwise decoding result provided from the Viterbi decoding unit 202 into the bytewise decoding result and performs de-interleaving on the bytewise decoding result obtained as a result of the conversion. The byte de-interleaver 203 provides the de-interleaved bytewise decoding result to the RS decoding unit 204.

Similar to the RS decoding unit 15, the RS decoding unit 204 performs RS decoding on the bytewise decoding result provided from the byte de-interleaver 203. The RS decoding unit 15 provides the decoded data obtained as a result to the decoder 25 of FIG. 2.

The likelihood provided from the demodulating unit 23 of FIG. 2 is input to the Viterbi decoding unit 13, and the first error correction process is performed by the Viterbi decoding unit 13, the byte de-interleaver 14, the RS decoding unit 15, the synchronous byte processing unit 32, a byte interleaver 205, and the state generating unit 133.

Specifically, when the likelihood is input from the demodulating unit 23 of FIG. 2, the bytewise decoded data and decoding success flag are output to the byte interleaver 205 through the Viterbi decoding unit 13, the byte de-interleaver 14, the RS decoding unit 15, and the synchronous byte processing unit 32.

The byte interleaver 205 has the same configuration as the byte interleaver 16 and performs bytewise interleaving on the decoding success flag and the decoded data by associating the decoded data with the decoding success flag provided from the synchronous byte processing unit 32. The byte interleaver 16 provides the interleaved bytewise decoded data and decoding success flag to the state generating unit 133. The bytewise decoded data and decoding success flag provided to the state generating unit 133 are used to generate the state and the reliability information of the state, and the generated state and reliability information of the state are provided to the Viterbi decoding unit 202.

In addition, the bytewise decoded data and decoding success flag output from the RS decoding unit 15 in the first error correction process are provided to the bit error counter 34 and used to calculate the number of bit errors. The calculated number of bit errors is output.

### [Description of process of error correcting unit of FIG. 16]

Similar to the error correction process of FIG. 6, in the error correction process of the error correcting unit 24 of FIG. 16, a first error correction process and a second error correction process are sequentially performed.

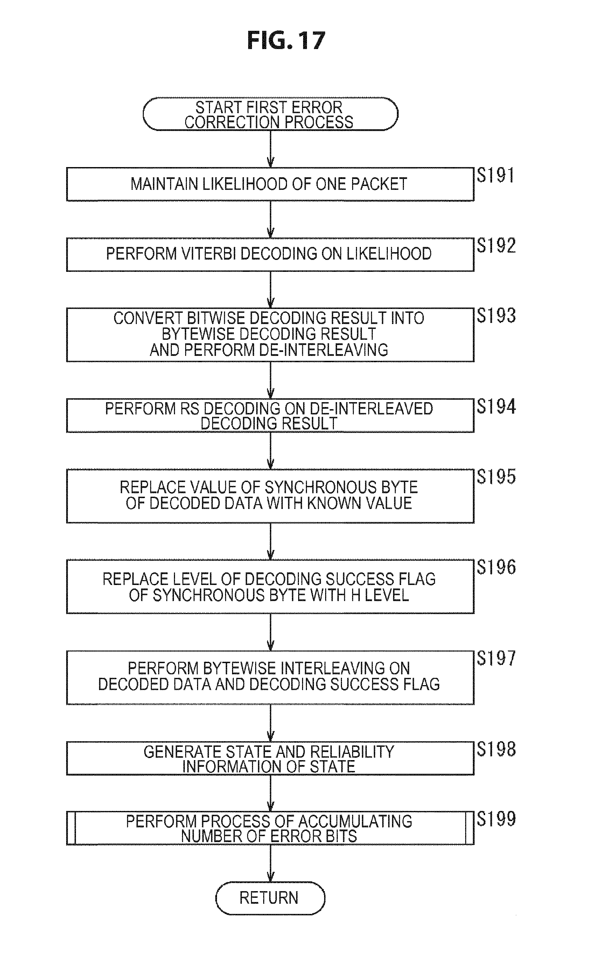

FIG. 17 is a flowchart illustrating details of the first error correction process of the error correcting unit 24 of FIG. 16.

In step S191 of FIG. 17, the delay unit 201 performs a delay by maintaining the likelihood of one packet provided from the demodulating unit 23 of FIG. 2. In step S192, the Viterbi decoding unit 13 performs Viterbi decoding on the likelihood provided from the demodulating unit 23 and provides the bitwise decoding result to the byte de-interleaver 14. Since the process of steps S193 to S196 is the same as the process of steps S125 to S128 of FIG. 13, descriptions thereof will not be provided.

In step S197, the byte interleaver 205 performs bytewise interleaving on the decoded data and the decoding success flag by associating the decoded data with the decoding success flag provided from the synchronous byte processing unit 32. The byte interleaver 16 provides the interleaved bytewise decoded data and decoding success flag to the state generating unit 133.

Since the process of steps S198 and S199 is the same as the process of steps S129 and S130 of FIG. 13, descriptions thereof will not be provided.

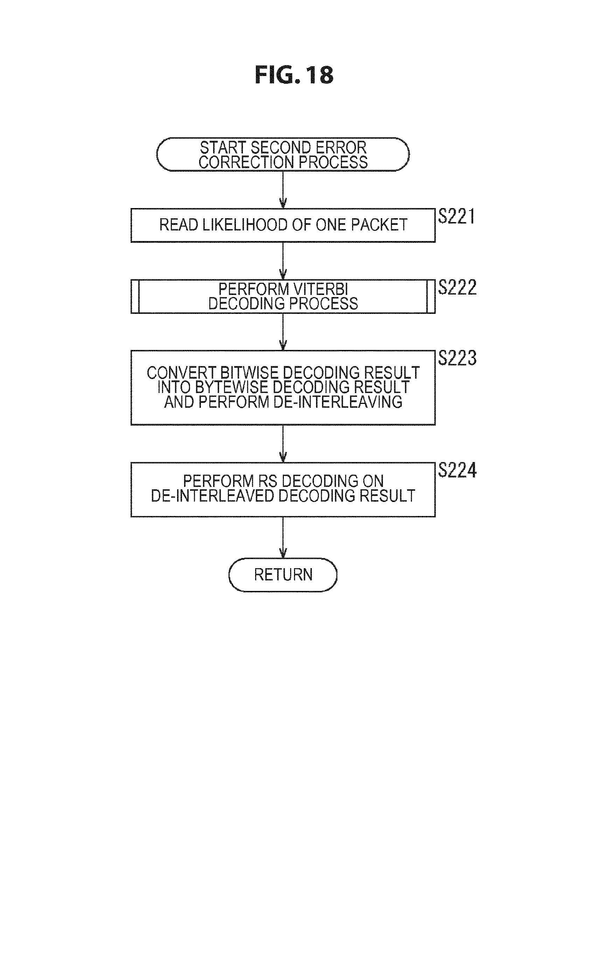

FIG. 18 is a flowchart illustrating details of the second error correction process of the error correcting unit 24 of FIG. 16.

In step S221 of FIG. 18, the delay unit 201 reads the likelihood of one packet being maintained as the likelihood after delay and provides the likelihood to the Viterbi decoding unit 202.

Since the process of steps S222 to S224 is the same as the process of steps S 175 to S 177 of FIG. 15, descriptions thereof will not be provided.

As described above, since the decoded data and the decoding success flag are interleaved, the error correcting unit 24 of FIG.16 may determine a state to be terminated based on a decoding result that has passed through a branch other than the zero delay branch. Therefore, the number of termination processes increases. As a result, reliability of the decoding result further increases.

### [Fourth configuration example of error correcting unit]

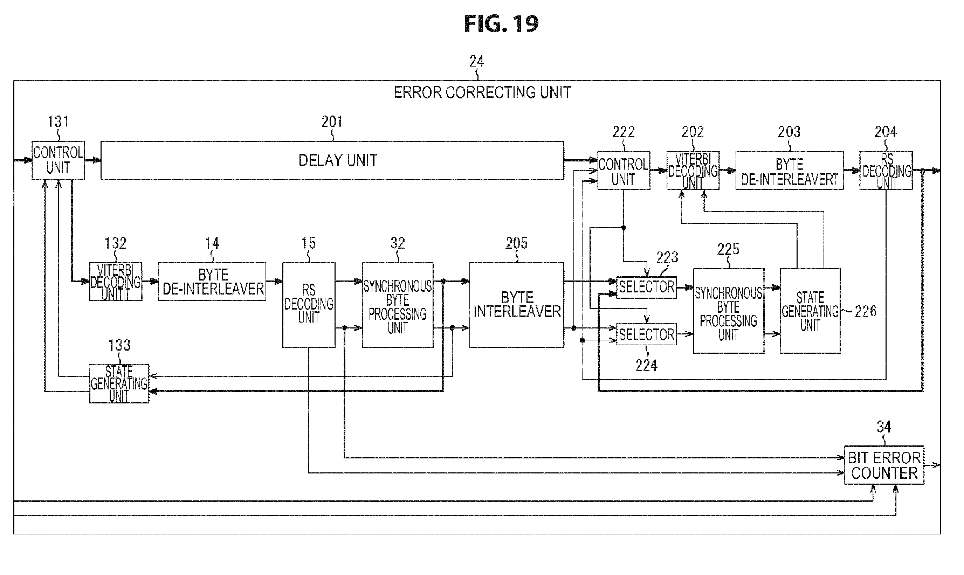

FIG. 19 is a block diagram illustrating a fourth configuration example of the error correcting unit 24 of FIG. 2.

Components illustrated in FIG. 19 that are the same as those in FIG. 3, FIG. 11, and FIG. 16 are denoted by the same reference numerals. Redundant description will be appropriately omitted. The error correcting unit 24 of FIG. 19 performs a termination process of Viterbi decoding based on the decoding result that has passed through the zero delay branch in the byte de-interleaver 14 and further performs a termination process of Viterbi decoding based on all decoding results obtained as a result. That is, the error correcting unit 24 of FIG. 19 is a combination of the error correcting unit 24 of FIG. 11 and the error correcting unit 24 of FIG. 16.

Specifically, similar to the error correcting unit 24 of FIG. 11, the control unit 131 the Viterbi decoding unit 132, the byte de-interleaver 14, the RS decoding unit 15, the synchronous byte processing unit 32, the state generating unit 133, and the bit error counter 34 of the error correcting unit 24 perform the error correction process on the likelihood provided from the demodulating unit 23 of FIG. 2.

The decoded data and the decoding success flag output from the RS decoding unit 15 as a result of the error correction process are provided again to the synchronous byte processing unit 32, replaced, and then provided to the byte interleaver 205.

The byte interleaver 205 has the same configuration as the byte interleaver 16 of FIG. 1 and performs bytewise interleaving by associating the decoded data with the decoding success flag provided from the byte interleaver 205. The interleaved decoded data is provided to a selector 223, and the decoding success flag is provided to a control unit 222 and a selector 224.

The delay unit 201, the control unit 222, the Viterbi decoding unit 202, the byte de-interleaver 203, the RS decoding unit 204, the selector 223, the selector 224, a synchronous byte processing unit 225, and a state generating unit 226 perform an error correction process similar to the error correction process of the error correcting unit 24 of FIG. 16 except that first decoding is controlled based on the decoded data and the decoding success flag obtained as a result of the error correction process that is the same as that performed by the error correcting unit 24 of FIG. 11 in the front-stage.

Specifically, the control unit 222 outputs the likelihood provided from the delay unit 201 to the Viterbi decoding unit 202. In addition, the control unit 222 provides a selection signal indicating selection of an input from the byte interleaver 205 to the selectors 223 and 224 corresponding to the decoding success flag provided from the byte interleaver 205. Also, the control unit 222 maintains the decoding success flag provided from the byte interleaver 205.

In addition, the control unit 222 includes a built-in memory and temporarily stores the likelihood provided from the delay unit 201. Also, when the decoding success flag is input from the RS decoding unit 204, the control unit 222 reads the stored likelihood corresponding to the state provided from the state generating unit 226 to the Viterbi decoding unit 202, outputs the likelihood to the Viterbi decoding unit 202 again, and reads the decoding success flag.

The control unit 222 provides a selection signal indicating selection of an input from the byte interleaver 205 or the RS decoding unit 204 to the selectors 223 and 224 based on the read decoding success flag.

The selector 223 provides the decoded data provided from the byte interleaver 205 or the decoded data provided from the RS decoding unit 204 to the synchronous byte processing unit 225 based on the selection signal provided from the control unit 222.

The selector 224 provides the decoding success flag provided from the byte interleaver 205 or the decoding success flag provided from the RS decoding unit 204 to the synchronous byte processing unit 225 based on the selection signal provided from the control unit 222.

Similar to the synchronous byte processing unit 32, the synchronous byte processing unit 225 replaces a value of a synchronous byte of the bytewise decoded data provided from the selector 223 with a known value. In addition, similar to the synchronous byte processing unit 32, the synchronous byte processing unit 225 replaces the level of the decoding success flag of the synchronous byte of the decoding success flag provided from the selector 224 with the H level. The synchronous byte processing unit 225 provides the replaced bytewise decoded data and decoding success flag to the state generating unit 226.

Similar to the state generating unit 133, the state generating unit 226 generates the state and the reliability information of the state based on the bytewise decoded data and decoding success flag provided from the synchronous byte processing unit 225. Then, the state generating unit 226 provides the state and reliability information of the state to the Viterbi decoding unit 202.

As described above, the error correcting unit 24 of FIG. 19 includes the first error correction processing unit including the control unit 131, the Viterbi decoding unit 132, the byte de-interleaver 14, the RS decoding unit 15, the synchronous byte processing unit 32, and the state generating unit 133 and the second error correction processing unit including the control unit 222, the Viterbi decoding unit 202, the byte de-interleaver 203, the RS decoding unit 204, the synchronous byte processing unit 225, and the state generating unit 226, which are connected in series through the byte interleaver 205 and the like.

Then, the state generating unit 226 of the second error correction processing unit of the rear-stage controls the Viterbi decoding unit 202 to increase reliability of a first decoding result using the decoded data and the decoding success flag that are obtained as a second decoding result by the first error correction processing unit of the front-stage and interleaved by the byte interleaver 205.

### [Description of process of error correcting unit of FIG. 19]

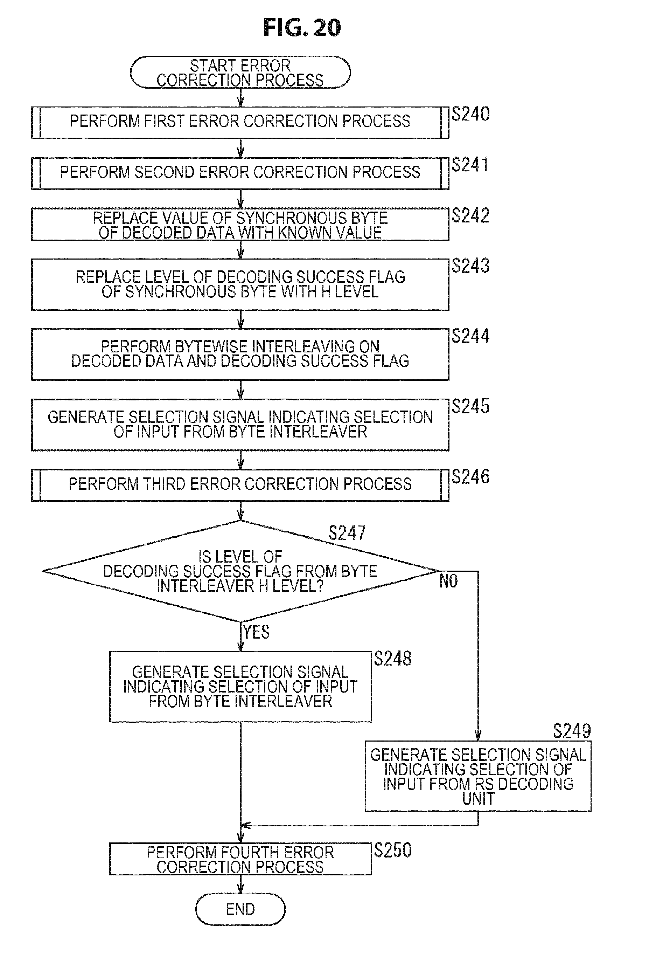

FIG. 20 is a flowchart illustrating the error correction process of the error correcting unit 24 of FIG. 19. The error correction process starts, for example, whenever the likelihood of one packet is input from the demodulating unit 23 of FIG. 2 and stored in the control unit 131.

In step S240 of FIG. 20, the error correcting unit 24 of FIG. 19 performs the first error correction process of FIG. 13. In step S241, the error correcting unit 24 performs the second error correction process of FIG. 15.

In step S242, the synchronous byte processing unit 32 obtains the bytewise decoded data obtained as a result of RS decoding by the RS decoding unit 15 in the second error correction process from the RS decoding unit 15 and replaces a value of a synchronous byte with a known value. Then, the synchronous byte processing unit 32 provides the replaced decoded data to the byte interleaver 205.

In step S243, the synchronous byte processing unit 32 obtains the decoding success flag obtained as a result of RS decoding by the RS decoding unit 15 in the second error correction process from the RS decoding unit 15 and replaces the level of the decoding success flag of the synchronous byte with the H level. Then, the synchronous byte processing unit 32 provides the replaced decoding success flag to the byte interleaver 205.

In step S244, the byte interleaver 205 performs bytewise interleaving on the decoded data and the decoding success flag by associating the decoded data with the decoding success flag provided from the synchronous byte processing unit 32.

The byte interleaver 205 provides the interleaved bytewise decoded data to the selector 223 and provides the decoding success flag to the control unit 222 and the selector 224. The control unit 222 maintains the decoding success flag provided from the byte interleaver 205.

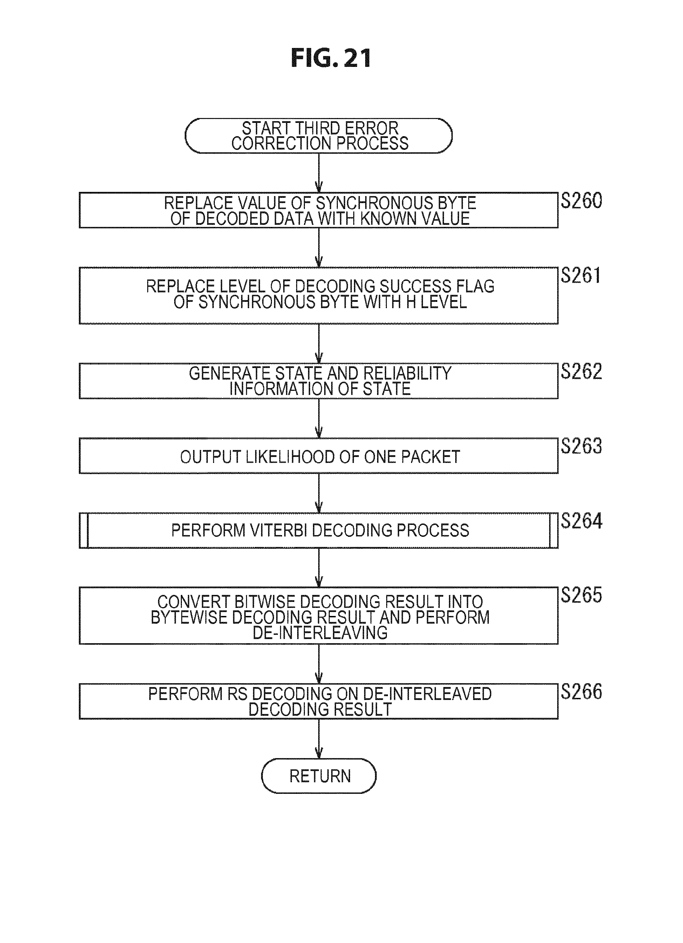

In step S245, the control unit 222 generates a selection signal indicating selection of an input from the byte interleaver 205 and provides the signal to the selectors 223 and 224. In step S246, the error correcting unit 24 performs a third error correction process that is a third error correction process of the likelihood of one packet. Details of the third error correction process will be described with reference to the following FIG. 21.

In step S247, the control unit 222 reads the maintained decoding success flag from the byte interleaver 205 and determines whether the level of the decoding success flag is the H level.

When it is determined in step S247 that the level of the decoding success flag from the byte interleaver 205 is the H level, the control unit 222 generates a selection signal indicating selection of an input from the byte interleaver 205 in step S248. Then, the control unit 222 provides the selection signal to the selectors 223 and 224, and the process advances to step S250.

On the other hand, when it is determined in step S247 that the level of the decoding success flag from the byte interleaver 205 is not the H level, that is, when the level of the decoding success flag is the L level, the process advances to step S249.

In step S249, the control unit 222 generates a selection signal indicating selection of an input from the RS decoding unit 204. Then, the control unit 222 provides the selection signal to the selectors 223 and 224, and the process advances to step S250.

In step S250, the error correcting unit 24 performs a fourth error correction process that is a fourth error correction process of the likelihood of one packet. The fourth error correction process is similar to the third error correction process of step S246 except that the control unit 222 does not output the likelihood provided from the delay unit 201 to the Viterbi decoding unit 202, but reads the likelihood maintained in the built-in memory and outputs the likelihood to the Viterbi decoding unit 202. Therefore, detailed description thereof will not be repeated. After the process of step S250, the error correction process is terminated.

FIG. 21 is a flowchart illustrating details of the third error correction process of step S246 of FIG. 20.

In step S260 of FIG. 21, the synchronous byte processing unit 225 replaces a value of a synchronous byte of the bytewise decoded data provided from the selector 223 with a known value and provides the value to the state generating unit 226. In step S261, the synchronous byte processing unit 225 replaces the level of the decoding success flag of the synchronous byte of the decoding success flag provided from the selector 224 with the H level and provides the level to the state generating unit 226.

In step S262, the state generating unit 226 generates the state and the reliability information of the state based on the bytewise decoded data and decoding success flag provided from the synchronous byte processing unit 225. Then, the state generating unit 226 provides the state and the reliability information of the state to the Viterbi decoding unit 202.

In step S263, the control unit 222 obtains the likelihood of one packet that is read by first reading from the control unit 131 and delayed by the delay unit 201 and outputs the likelihood to the Viterbi decoding unit 202. Since the process of steps S264 to S266 is the same as the process of steps S222 to S224 of FIG. 18, descriptions thereof will not be provided.

As described above, the error correcting unit 24 of FIG. 19 performs a termination process of Viterbi decoding based on the decoding result that has passed through the zero delay branch in the byte de-interleaver 14 and further performs a termination process of Viterbi decoding based on all decoding results obtained as a result. Therefore, compared to the error correcting unit 24 of FIG. 16, it is possible to further increase reliability of the decoding result. In addition, the error correcting unit 24 of FIG. 19 has a circuit scale that is not excessively increased compared to the error correcting unit 24 of FIG. 16. Accordingly, the error correcting unit 24 of FIG. 19 may increase reliability of the decoding result without excessively increasing a circuit scale compared to the error correcting unit 24 of FIG. 16.

In addition, since the error correcting unit 24 of FIG. 19 performs a first termination process based on only the decoding result that has passed through the zero delay branch, only one byte interleaver 205 need be provided.

### [Fifth configuration example of error correcting unit]

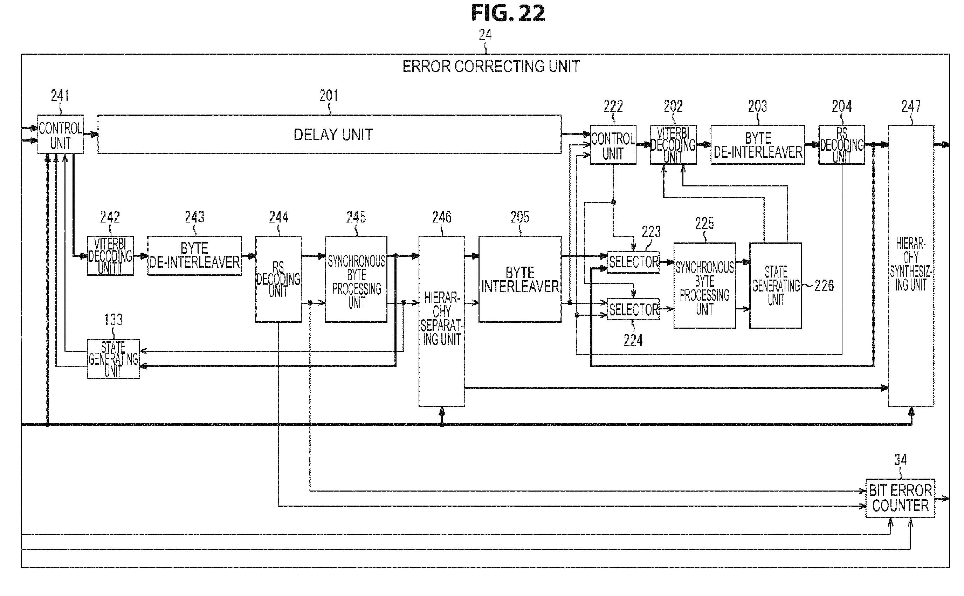

FIG. 22 is a block diagram illustrating a fifth configuration example of the error correcting unit 24 of FIG. 2.

Components illustrated in FIG. 22 3 that are the same as those in FIG. 19 are denoted by the same reference numerals. Redundant description will be appropriately omitted.

A configuration of the error correcting unit 24 of FIG. 22 is mainly different from the configuration of FIG. 19 in that a control unit 241, a Viterbi decoding unit 242, a byte de-interleaver 243, an RS decoding unit 244, and a synchronous byte processing unit 245 are provided instead of the control unit 131, the Viterbi decoding unit 132, the byte de-interleaver 14, the RS decoding unit 15, and the synchronous byte processing unit 32, and a hierarchy separating unit 246 and a hierarchy synthesizing unit 247 are newly provided.

The error correcting unit 24 of FIG. 22 performs the third and fourth error correction processes according to a hierarchy of a modulation scheme corresponding to the likelihood. In the ISDB-T standard, the hierarchy of the modulation scheme includes three hierarchies, hierarchies A to C.

Similar to the control unit 131, the control unit 241 of the error correcting unit 24 includes a built-in memory and temporarily stores the likelihood provided from the demodulating unit 23 of FIG. 2 and hierarchy information representing a type of the hierarchy of the modulation scheme input from the outside. Then, when the likelihood of a predetermined unit (for example, in units of packets) is stored in the built-in memory, the control unit 241 performs first reading of the likelihood and provides the read likelihood to the Viterbi decoding unit 242.

In this case, similar to the control unit 131, the control unit 241 provides the predetermined value as the state and the reliability information of the state of the L level to the Viterbi decoding unit 242. In addition, the control unit 241 reads hierarchy information and provides a likelihood of a predetermined hierarchy among the read likelihoods based on the hierarchy information and segment information representing the number of segments of each hierarchy input from the outside to the delay unit 201.

In addition, when the reliability information of the state and the state are output from the state generating unit 133, the control unit 241 performs second reading of the likelihood of a predetermined unit and the hierarchy information and provides the result to the Viterbi decoding unit 242. In this case, similar to the control unit 131, when the reliability information of the state and the state provided from the state generating unit 133 correspond to the decoding result that has passed through the zero delay branch in the byte de-interleaver 14, the control unit 241 provides the reliability information of the state and the state to the Viterbi decoding unit 242.

On the other hand, when the reliability information of the state and the state provided from the state generating unit 133 do not correspond to the decoding result that has passed through the zero delay branch in the byte de-interleaver 14, the control unit 241 provides the predetermined value as the state and the reliability information of the state of the L level to the Viterbi decoding unit 242, similar to the control unit 131.

The Viterbi decoding unit 242, the byte de-interleaver 243, the RS decoding unit 244, and the synchronous byte processing unit 245 are similar to the Viterbi decoding unit 132, the byte de-interleaver 14, the RS decoding unit 15, and the synchronous byte processing unit 32, respectively, except that the hierarchy information is input and the hierarchy information is output to the rear-stage.

Based on the segment information from the outside and the hierarchy information from the synchronous byte processing unit 245, the hierarchy separating unit 246 provides the decoded data and the decoding success flag of a predetermined hierarchy among the bytewise decoded data and decoding success flag provided from the synchronous byte processing unit 245 to the byte interleaver 205. In addition, the hierarchy separating unit 246 provides decoded data of a hierarchy other than the predetermined hierarchy to the hierarchy synthesizing unit 247.

The hierarchy synthesizing unit 247 outputs the bytewise decoded data provided from the hierarchy separating unit 246 and the bytewise decoded data provided from the RS decoding unit 204 according to a hierarchical order of input to the error correcting unit 24 based on the segment information from the outside. As a method of outputting the decoded data according to the hierarchical order of input to the error correcting unit 24, a method in which decoded data is numbered in the order in which it was provided to the hierarchy separating unit 246 from the synchronous byte processing unit 245 and the hierarchy synthesizing unit 247 outputs the decoded data according to the numbering is exemplified.

### [Description of process of error correcting unit of FIG. 22]

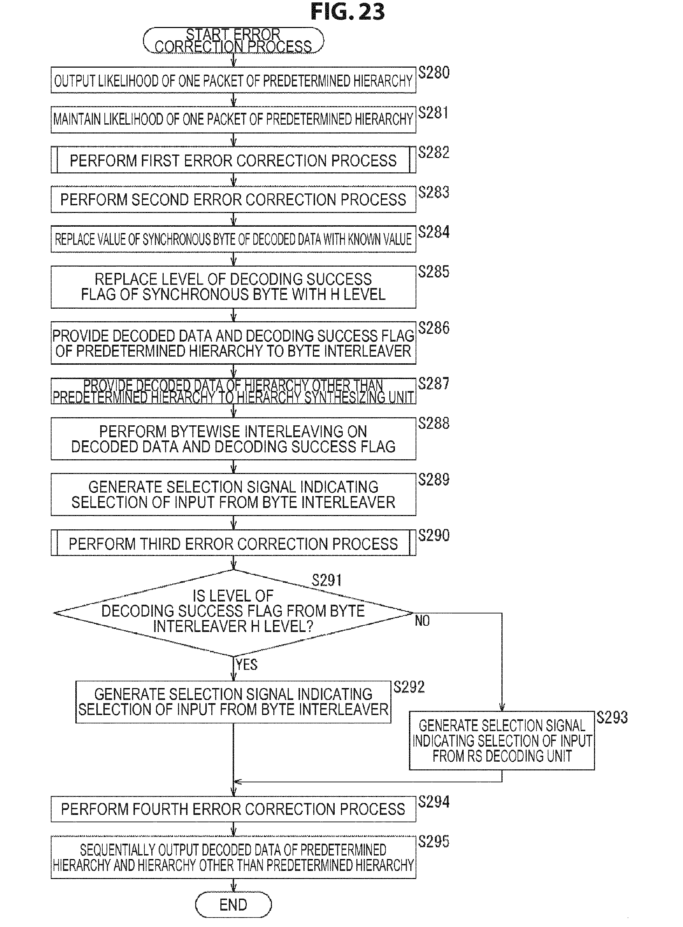

FIG. 23 is a flowchart illustrating the error correction process of the error correcting unit 24 of FIG. 22. The error correction process starts, for example, whenever the likelihood of one packet is input from the demodulating unit 23 of FIG. 2, the hierarchy information is input from the outside, and the likelihood of one packet is stored in the control unit 241.

In step S280 of FIG. 23, the control unit 241 reads the stored likelihood of one packet and the hierarchy information and outputs a likelihood of one packet of a predetermined hierarchy to the delay unit 201 based on the likelihood and the hierarchy information as well as the segment information input from the outside.

When a hierarchy of all segments is, for example, hierarchy A, that is, when the number of segments of hierarchy A represented by segment information is the number of all segments and the number of segments of hierarchy B and hierarchy C is 0, the control unit 241 provides a likelihood of one packet of hierarchy A to the delay unit 201. On the other hand, when the number of segments of hierarchy A is 1 and the number of segments of hierarchy B is 12, the control unit 241 provides only the likelihood of one packet of hierarchy B to the delay unit 201. Also, when a hierarchy of each segment is a hierarchy other than the above-described hierarchies, the control unit 241 provides nothing to the delay unit 201.

In step S281, the delay unit 201 performs a delay by maintaining the likelihood of one packet of a predetermined hierarchy provided from the control unit 241. The delay unit 201 provides the likelihood after delay to the control unit 222.

In step S282, the error correcting unit 24 performs the first error correction process of FIG. 13. In step S283, the second error correction process is performed. The second error correction process is similar to the second error correction process of FIG. 15 except that the hierarchy information is provided to the synchronous byte processing unit 245 through the Viterbi decoding unit 242, the byte de-interleaver 243, and the RS decoding unit 244.

In step S284, the synchronous byte processing unit 245 obtains the bytewise decoded data obtained as a result of RS decoding by the RS decoding unit 244 in the second error correction process from the RS decoding unit 244 and replaces a value of a synchronous byte with a known value. Then, the synchronous byte processing unit 245 provides the replaced decoded data to the hierarchy separating unit 246.

In step S285, the synchronous byte processing unit 245 obtains the decoding success flag obtained as a result of RS decoding by the RS decoding unit 244 in the second error correction process from the RS decoding unit 244 and replaces the level of the decoding success flag of the synchronous byte with the H level. Then, the synchronous byte processing unit 245 provides the replaced decoding success flag to the hierarchy separating unit 246. In addition, the synchronous byte processing unit 245 provides the hierarchy information provided from the RS decoding unit 244 to the hierarchy separating unit 246.

In step S286, the hierarchy separating unit 246 provides the bytewise decoded data and decoding success flag of a predetermined hierarchy provided from the synchronous byte processing unit 245 to the byte interleaver 205 based on the segment information from the outside and the hierarchy information from the synchronous byte processing unit 245.

When a hierarchy of all segments is, for example, hierarchy A, the hierarchy separating unit 246 provides the bytewise decoded data and decoding success flag of hierarchy A to the byte interleaver 205. On the other hand, when the number of segments of hierarchy A is 1 and the number of segments of hierarchy B is 12, the hierarchy separating unit 246 provides the bytewise decoded data and decoding success flag of hierarchy B to the byte interleaver 205. In addition, when a hierarchy of each segment is a hierarchy other than the above-described hierarchies, the hierarchy separating unit 246 provides nothing to the byte interleaver 205.

In step S287, the hierarchy separating unit 246 provides the bytewise decoded data of a hierarchy other than the predetermined hierarchy to the hierarchy synthesizing unit 247.

When a hierarchy of all segments is, for example, hierarchy A, the hierarchy separating unit 246 provides nothing to the hierarchy synthesizing unit 247. On the other hand, when the number of segments of hierarchy A is 1 and the number of segments of hierarchy B is 12, the hierarchy separating unit 246 provides the bytewise decoded data of hierarchy A to the hierarchy synthesizing unit 247. In addition, when a hierarchy of each segment is a hierarchy other than the above-described hierarchies, the hierarchy separating unit 246 provides decoded data of all hierarchies to the hierarchy synthesizing unit 247.

Since the process of steps S288 to S294 is the same as the process of steps S244 to S250 of FIG. 20, descriptions thereof will not be provided.

In step S295, the hierarchy synthesizing unit 247 outputs the bytewise decoded data of a predetermined hierarchy provided from the RS decoding unit 204 and the bytewise decoded data of a hierarchy other than the predetermined hierarchy provided from the hierarchy separating unit 246 in a hierarchical order of input to the error correcting unit 24 based on the segment information from the outside. Then, the error correction process is terminated.

As described above, the error correcting unit 24 of FIG. 22 performs a second termination process on only a signal of the predetermined hierarchy. Therefore, since only the decoded data and the decoding success flag of the predetermined hierarchy are maintained in the byte interleaver 205 and only the likelihood of the predetermined hierarchy is maintained in the control unit 222, it is possible to decrease the memory for the error correction process.

### [Configuration Example of Computer to Which Present Technology is Applied]

The series of processes described above can be executed by hardware but can also be executed by software. When the series of processes is executed by software, a program that constructs such software is installed into a computer. Here, the expression "computer" includes a computer in which dedicated hardware is incorporated and a general-purpose personal computer or the like that is capable of executing various functions when various programs are installed.

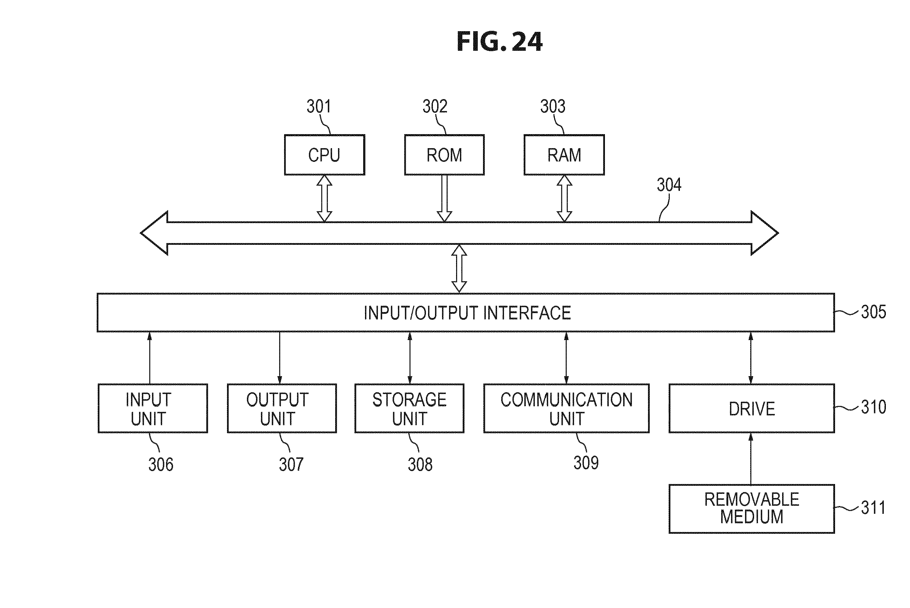

FIG. 24 is a block diagram showing an example configuration of the hardware of a computer that executes the series of processes described earlier according to a program.

In the computer, a central processing unit (CPU) 301, a read only memory (ROM) 302 and a random access memory (RAM) 303 are mutually connected by a bus 304.

An input/output interface 315 is also connected to the bus 304. An input unit 306, an output unit 307, a storage unit 308, a communication unit 309, and a drive 310 are connected to the input/output interface 305.

The input unit 306 is configured from a keyboard, a mouse, a microphone or the like. The output unit 307 is configured from a display, a speaker or the like. The storage unit 308 is configured from a hard disk, a non-volatile memory or the like. The communication unit 309 is configured from a network interface or the like. The drive 310 drives a removable medium 311 such as a magnetic disk, an optical disk, a magneto-optical disk, a semiconductor memory or the like.

In the computer configured as described above, the CPU 301 loads a program that is stored, for example, in the storage unit 308 onto the RAM 303 via the input/output interface 305 and the bus 304, and executes the program. Thus, the above-described series of processing is performed.

Programs to be executed by the computer (the CPU 301) are provided being recorded in the removable medium 311 which is a packaged medium or the like. Also, programs may be provided via a wired or wireless transmission medium, such as a local area network, the Internet or digital satellite broadcasting.

In the computer, by loading the removable medium 311 into the drive 310, the program can be installed into the storage unit 308 via the input/output interface 305. It is also possible to receive the program from a wired or wireless transfer medium using the communication unit 309 and install the program into the storage unit 308. As another alternative, the program can be installed in advance into the ROM 302 or the storage unit 308.

It should be noted that the program executed by a computer may be a program that is processed in time series according to the sequence described in this specification or a program that is processed in parallel or at necessary timing such as upon calling.

An embodiment of the disclosure is not limited to the embodiments described above, and various changes and modifications may be made without departing from the scope of the disclosure.

For example, the present disclosure may also be applied to a receiving device compliant with a standard other than the ISDB-T standard. For example, the present disclosure may be applied to a receiving device compliant with a DVB-T standard, an ATSC standard, an ISDB-S standard, and a DVB-S standard rather than the ISDB-T standard in which an RS code is used as an external code and a convolutional code is used as an internal code.

However, for example, in the DVB-T standard, a value of a synchronous byte for every 8 packets is 0xB8 once, and 0x47 thereafter. In addition, a delay of 11 packets occurs in the byte interleaver or byte de-interleaver. Therefore, when the delay is considered, the synchronous byte of the decoded data is replaced with 0x47 or 0xB8.

In addition, the present disclosure may also be applied to a receiving device compliant with a standard in which an RS code is used as an external code and an LDPC code is used as an internal code. In this case, in the above-described embodiments, LDPC decoding is performed instead of Viterbi decoding. Further, the present disclosure may also be applied to a receiving device compliant with a DVB-T2 standard, a DVB-C2 standard, and a DVB-S2 standard in which a BCH code is used as an external code and an LDPC code is used as an internal code. In this case, in the above-described embodiments, LDPC decoding instead of Viterbi decoding and BCH decoding instead of RS decoding are performed.

Further, the number of error correction processing units is not limited to two.

In addition, the error correcting unit 24 of FIG. 19 is a combination of the error correcting unit 24 of FIG. 11 and the error correcting unit 24 of FIG. 16. The error correcting unit 24 of FIG. 3 may be combined instead of the error correcting unit 24 of FIG. 11.

Additionally, the present technology may also be configured as below.

(1)
   A receiving device including:
   a receiving unit configured to receive encoded data encoded by one or more codes;
   a first decoding unit configured to decode the encoded data received by the receiving unit;
   a first delay unit configured to delay a part of decoding results obtained by the first decoding unit; and
   a reliability increasing unit configured to control decoding of the encoded data to increase reliability of the decoding results using a decoding result that is not delayed by the first delay unit among the decoding results after delay by the first delay unit.
(2)
   The receiving device according to (1),
   wherein the first decoding unit decodes the encoded data again according to control of the reliability increasing unit.
(3)
   The receiving device according to (2),
   wherein a plurality of error correction processing units including the first decoding unit, the first delay unit, and the reliability increasing unit are connected in series, and
   wherein the reliability increasing unit controls first decoding of the encoded data to increase reliability of the decoding results using a decoding result obtained by decoding again by the first decoding unit of the error correction processing unit of a front-stage.
(4)
   The receiving device according to (3), further including:
   an interleaving unit provided between the error correction processing units and configured to perform interleaving on a decoding result obtained as a result of decoding again by the first decoding unit of the error correction processing unit of a front-stage, the interleaving corresponding to de-interleaving as a delay by the first delay unit of the error correction processing unit of the front-stage,
   wherein the reliability increasing unit controls first decoding of the encoded data to increase reliability of the decoding results using a decoding result that is interleaved by the interleaving unit of the front-stage.
(5)
   The receiving device according to (4), further including:
   a synthesizing unit configured to synthesize a decoding result obtained as a result of decoding again by the first decoding unit of each error correction processing unit,
   wherein the interleaving unit performs the interleaving on a decoding result corresponding to encoded data of a predetermined hierarchy among decoding results obtained as a result of decoding again by the first decoding unit of the front-stage.
(6)
   The receiving device according to any of (1) to (5), further including:
   a replacement unit configured to replace a value of a position corresponding to a position of a known value of the encoded data of decoded data as a decoding result after delay by the first delay unit with the known value,
   wherein the reliability increasing unit controls decoding of the encoded data to increase reliability of the decoding results using a decoding result that is not delayed by the first delay unit among the decoding results replaced by the replacement unit.
(7)
   The receiving device according to any of (1) to (6),
   wherein the one or more codes include an external code and an internal code, and
   wherein the first decoding unit performs decoding corresponding to the external code and the internal code.
(8)
   The receiving device according to (7),
   wherein the external code is a Reed Solomon (RS) code,
   wherein the internal code is a convolutional code,
   wherein the first delay unit performs de-interleaving by delaying a part of the decoding result, and
   wherein the reliability increasing unit controls decoding of the encoded data to increase reliability of the decoding results using a decoding result that has passed through a zero delay branch in the de-interleaving among the decoding results after the de-interleaving by the first delay unit.
(9)
   The receiving device according to (7),
   wherein the external code is a Bose Chaudhuri Hocquenghem (BCH) code, and
   wherein the internal code is a low density parity check (LDPC) code.
(10)
   The receiving device according to any of (1) to (8),
   wherein the reliability increasing unit controls the decoding in a manner that a likelihood of the encoded data is converted into a likelihood that is closest to 0 or 1 based on a decoding result that is not delayed by the first delay unit, and the converted likelihood is then decoded.
(11)
   The receiving device according to any of (1) to (8),
   wherein the decoding is Viterbi decoding, and
   wherein the reliability increasing unit controls the Viterbi decoding in a manner that a state in a trellis in the Viterbi decoding is determined based on a decoding result that is not delayed by the first delay unit and reliability of the state becomes the highest.
(12)
   The receiving device according to any of (1) to (11), further including:
   a calculating unit configured to calculate the number of bit errors of the encoded data based on a decoding result of first decoding by the first decoding unit.
(13)
   A receiving method including, by a receiving device:
   a receiving step of receiving encoded data encoded by one or more codes;
   a first decoding step of decoding the encoded data received by a process of the receiving step;
   a first delaying step of delaying a part of decoding results obtained by a process of the first decoding step; and
   a reliability increasing step of controlling decoding of the encoded data to increase reliability of the decoding results using a decoding result that is not delayed by a process of the first delaying step among the decoding results after delay by the process of the first delaying step.

### Reference Signs List

- 12: likelihood converting unit
- 13: Viterbi decoding unit
- 14: byte de-interleaver
- 15: RS decoding unit
- 20: receiving device
- 21: antenna
- 32: synchronous byte processing unit
- 34: bit error counter
- 132: Viterbi decoding unit
- 133: state generating unit
- 202: Viterbi decoding unit
- 204: RS decoding unit
- 205: byte interleaver
- 247: hierarchy synthesizing unit

## Claims

1. A receiving device comprising:
a receiving unit configured to receive encoded data encoded by one or more codes;
a first decoding unit configured to decode the encoded data received by the receiving unit;
a first delay unit configured to delay a part of decoding results obtained by the first decoding unit; and
a reliability increasing unit configured to control decoding of the encoded data to increase reliability of the decoding results using a decoding result that is not delayed by the first delay unit among the decoding results after delay by the first delay unit.

2. The receiving device according to claim 1,
wherein the first decoding unit decodes the encoded data again according to control of the reliability increasing unit.

3. The receiving device according to claim 2,
wherein a plurality of error correction processing units including the first decoding unit, the first delay unit, and the reliability increasing unit are connected in series, and
wherein the reliability increasing unit controls first decoding of the encoded data to increase reliability of the decoding results using a decoding result obtained by decoding again by the first decoding unit of the error correction processing unit of a front-stage.

4. The receiving device according to claim 3, further comprising:
an interleaving unit provided between the error correction processing units and configured to perform interleaving on a decoding result obtained as a result of decoding again by the first decoding unit of the error correction processing unit of a front-stage, the interleaving corresponding to de-interleaving as a delay by the first delay unit of the error correction processing unit of the front-stage,
wherein the reliability increasing unit controls first decoding of the encoded data to increase reliability of the decoding results using a decoding result that is interleaved by the interleaving unit of the front-stage.

5. The receiving device according to claim 4, further comprising:
a synthesizing unit configured to synthesize a decoding result obtained as a result of decoding again by the first decoding unit of each error correction processing unit,
wherein the interleaving unit performs the interleaving on a decoding result corresponding to encoded data of a predetermined hierarchy among decoding results obtained as a result of decoding again by the first decoding unit of the front-stage.

6. The receiving device according to claim 1, further comprising:
a replacement unit configured to replace a value of a position corresponding to a position of a known value of the encoded data of decoded data as a decoding result after delay by the first delay unit with the known value,
wherein the reliability increasing unit controls decoding of the encoded data to increase reliability of the decoding results using a decoding result that is not delayed by the first delay unit among the decoding results replaced by the replacement unit.

7. The receiving device according to claim 1,
wherein the one or more codes include an external code and an internal code, and
wherein the first decoding unit performs decoding corresponding to the external code and the internal code.

8. The receiving device according to claim 7,
wherein the external code is a Reed Solomon (RS) code,
wherein the internal code is a convolutional code,
wherein the first delay unit performs de-interleaving by delaying a part of the decoding result, and
wherein the reliability increasing unit controls decoding of the encoded data to increase reliability of the decoding results using a decoding result that has passed through a zero delay branch in the de-interleaving among the decoding results after the de-interleaving by the first delay unit.

9. The receiving device according to claim 7,
wherein the external code is a Bose Chaudhuri Hocquenghem (BCH) code, and
wherein the internal code is a low density parity check (LDPC) code.

10. The receiving device according to claim 1,
wherein the reliability increasing unit controls the decoding in a manner that a likelihood of the encoded data is converted into a likelihood that is closest to 0 or 1 based on a decoding result that is not delayed by the first delay unit, and the converted likelihood is then decoded.

11. The receiving device according to claim 1,
wherein the decoding is Viterbi decoding, and
wherein the reliability increasing unit controls the Viterbi decoding in a manner that a state in a trellis in the Viterbi decoding is determined based on a decoding result that is not delayed by the first delay unit and reliability of the state becomes the highest.

12. The receiving device according to claim 1, further comprising:
a calculating unit configured to calculate the number of bit errors of the encoded data based on a decoding result of first decoding by the first decoding unit.

13. A receiving method comprising, by a receiving device:
a receiving step of receiving encoded data encoded by one or more codes;
a first decoding step of decoding the encoded data received by a process of the receiving step;
a first delaying step of delaying a part of decoding results obtained by a process of the first decoding step; and
a reliability increasing step of controlling decoding of the encoded data to increase reliability of the decoding results using a decoding result that is not delayed by a process of the first delaying step among the decoding results after delay by the process of the first delaying step.
